# EUROPEAN PATENT APPLICATION

(11) **EP 1 726 608 A1**
(43) Date of publication of application: **29.11.2006**
(21) Application number: 05720982.7
(22) Date of filing: 17.03.2005
(51) Int. Cl.: C08G 77/14, G03F 7/039, G03F 7/075, H01L 21/027

(54) **RADIATION-SENSITIVE RESIN COMPOSITION**

(30) Priority: 17.03.2004 JP 2004076647
(71) Applicant: JSR Corporation, Tokyo 104-8410 (JP)
(72) Inventor: NISHIMURA, Isao, JSR Corp., Chuo-Ku, Tokyo 1048410 (JP); SUGIURA, Makoto, JSR Corp.. 6-10, Chuo-Ku, Tokyo 1048410 (JP); TANAKA, Masato, JSR Corp., Chuo-Ku, Tokyo 1048410 (JP)
(74) Representative: TBK-Patent
(86) International application number: PCT/JP2005/004747
(87) International publication number: WO 2005/087841

(57) **Abstract**

A siloxane resin exhibiting high transparency at a wavelength of 193 nm or less, very suitable as a resin component in a radiation-sensitive resin composition useful particularly for manufacturing LSIs, and a radiation-sensitive resin composition useful as a chemically-amplified resist exhibiting excellent depth of focus (DOF) and capability of remarkably decreasing development defects are provided.

The siloxane resin comprises the structural unit (I) shown by the following formula (I) and the structural unit (II) shown by the following formula (II) in the same molecule, the structural unit (I) and the structural unit (II) being included in an amount of more than 0 mol% but not more than 70 mol%, 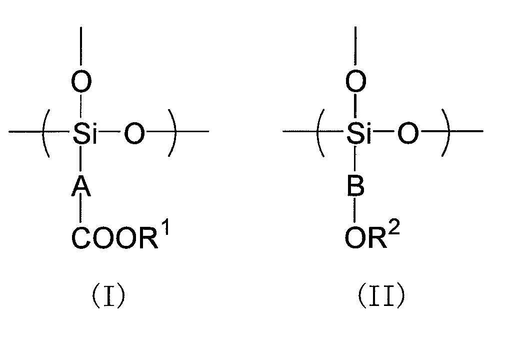 wherein A and B individually represents a divalent linear, branched, or cyclic hydrocarbon group, R¹ represents a monovalent acid-dissociable group, and R² represents a linear, branched, or cyclic alkyl group.

The radiation-sensitive resin composition comprises (a) the siloxane resin and (b) a photoacid generator.

## Description

### TECHNICAL FIELD

The present invention relates to a radiation-sensitive resin composition containing a specific siloxane resin suitable for microprocessing using various types of radiation such as deep ultraviolet radiation, electron beams, and X-rays.

### BACKGROUND ART

A recent strong demand for high density and highly integrated LSIs (large-scale integrated circuits) radically accelerates miniaturization of wiring patterns.

Using short wavelength rays in a lithographic process is one method for miniaturizing wiring patterns. In recent years, deep ultraviolet rays typified by a KrF excimer laser (wavelength: 248 nm), an ArF excimer laser (wavelength: 193 nm), or an F₂ excimer laser (wavelength: 157 nm), electron beams, X rays, and the like are being used in place of ultraviolet rays such as g-line (wavelength: 436 nm), and i-line (wavelength: 365 nm).

Novolac resins, poly(vinylphenol) resins, and the like have been conventionally used as a resin component in resist compositions. However, because these resins exhibit strong absorbance at a wavelength of 193 nm due to inclusion of aromatic rings in the structure, a lithographic process by an ArF excimer laser, for example, using these resins cannot provide high accuracy corresponding to high photosensitivity, high resolution, and a high aspect ratio.

Therefore, a resin for use in a resist, transparent to a wavelength of 193 nm or less, particularly to an ArF excimer laser (wavelength: 193 nm) or an F₂ excimer laser (wavelength: 157 nm), and exhibiting the same or higher dry etching resistance as the resist resin containing aromatic rings, has been desired. A siloxane polymer is one such a polymer. R. R. Kunz et al. of the MIT have reported their research results showing excellent transparency of a siloxane polymer at a wavelength of 193 nm or less, particularly at 157 nm, describing superiority of this polymer as a resist in a lithographic process using radiation with a wavelength of 193 nm or less (e.g. Non-patent Document 1, Non-patent Document 2). Moreover, polysiloxanes are known to exhibit excellent dry etching resistance. In particular, a resist containing polyorganosilsesquioxane having a ladder structure is known to possess high plasma resistance.

Several chemically-amplified resist compositions using a siloxane polymer have also been reported. A radiation-sensitive resin composition comprising a polysiloxane having an acid-dissociable group such as a carboxylic acid ester group, phenol ether group, etc., on the side chain, bonded to a silicon atom via one or more carbon atoms has been disclosed (e.g. Patent Document 1). However, this polysiloxane cannot provide high resolution if the acid-dissociable carboxylic acid ester groups on the side chain do not efficiently dissociate. If a large number of acid-dissociable groups dissociate, on the other hand, the curing shrinkage stress of the resist film increases, causing cracks and peels in the resist film.

A positive tone resist using a polymer in which the carboxyl group of poly(2-carboxyethylsiloxane) is protected with an acid-dissociable group such as a t-butyl group has also been disclosed (e.g. Patent Document 2). Since this resist protects the carboxyl groups only insufficiently, it is difficult to develop the resist containing a large amount of carboxylic acid components remaining in the non-exposed area using a common alkaline developing solution.

A resist resin composition containing a polyorganosilsesquioxane having an acid-dissociable ester group has also been disclosed (e.g. Patent Document 3). This polyorganosilsesquioxane is prepared by the addition reaction of an acid-dissociable group-containing (meth)acryl monomer to a condensation product of vinyltrialkoxysilane, γ-methacryloxypropyltrialkoxysilane, or the like. The resin has a problem of insufficient transparency to light with a wavelength of 193 nm or less due to unsaturated groups originating from a (meth)acryl monomer remaining on the polymer side chains. The patent specification also describes a resist resin composition containing a polymer made by the esterification of polyhydroxycarbonylethylsilsesquioxane with t-butyl alcohol. This polymer also has the same problem as a resist as encountered by the polymer disclosed in Patent Document 2 due to a low degree of carboxyl group protection.

More recently, Patent Document 4 and Patent Document 5 have disclosed chemically amplified resists in which the resin component contains a siloxane-based resin or silicon-containing resin and a silicon-free resin, such as a resist containing a silsesquioxane polymer and a copolymer of 2-methyl-2-adamantyl methacrylate and mevalonic methacrylate or a resist containing a copolymer of p-hydroxystyrene and tris(trimethylsilyl)silyl methacrylate and a copolymer of p-hydroxystyrene and t-butyl methacrylate. The inventors of these patent applications claim that these chemically amplified resists excel in sensitivity, resolution, pattern-forming properties, dry etching resistance, and the like.
Non-patent Document 1: J. Photopolym. Sci. Technol., Vol. 12, No. 4 (1999) P. 561-570
Non-patent document 2: SPIE, Vol. 3678 (1999) P. 13-23
Patent Document 1: JP-A-5-323611
Patent document 2: JP-A-8-160623
Patent Document 3: JP-A-11-60733
Patent document 4: JP-A-2000-221685
Patent document 5: JP-A-2000-221686

In addition to excellent sensitivity, resolution, and pattern profile, however, a more recent demand for chemically amplified resists, which may contain a siloxane polymer, includes excellent depth of focus (DOF) and capability of decreasing development defects that can respond to miniaturization of resist patterns.

### DISCLOSURE OF THE INVENTION

An object of the present invention is to provide a radiation-sensitive resin composition suitable for use particularly as a chemically-amplified resist exhibiting high transparency at a wavelength of 193 nm or less, excellent depth of focus (DOF), and capability of remarkably decreasing development defects.

The present invention provides a siloxane resin (hereinafter referred to "siloxane resin (α)") having a structural unit (I) shown by the following formula (I) and a structural unit (II) shown by the following formula (II) in the same molecule, the content of the structural unit (I) in the total structural units being more than 0 mol% but not more than 70 mol% and the content of the structural unit (II) in the total structural units being more than 0 mol% but not more than 70 mol%, and possessing a polystyrene-reduced weight average molecular weight determined by gel permeation chromatography (GPC) in the range of 500 to 1,000,000, 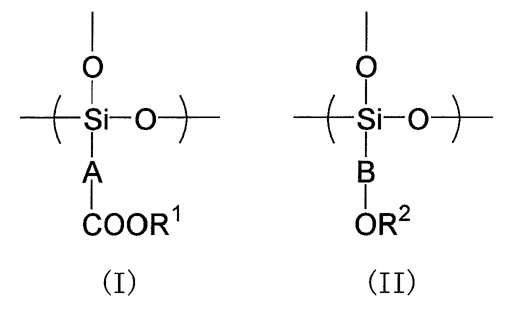 wherein A represents a substituted or unsubstituted divalent linear, branched, or cyclic hydrocarbon group having 1 to 20 carbon atoms and R¹ represents a monovalent acid-dissociable group and B represents a divalent linear, branched, or cyclic hydrocarbon group having 1 to 20 carbon atoms, which may be substituted with a group not containing a fluorine atom, and R² represents a substituted or unsubstituted linear, branched, or cyclic alkyl group having 1 to 20 carbon atoms.

The present invention further provides a radiation-sensitive resin composition comprising (a) the siloxane resin (α) and (b) a photoacid generator.

The present invention is described below in detail.

### <Siloxane resin (α)>

The siloxane resin (α) of the present invention is a siloxane resin comprising the structural unit (I) shown by the above formula (I) and the structural unit (II) shown by the above formula (II) in the same molecule.

As examples of the divalent linear, branched, or cyclic hydrocarbon group having 1 to 20 carbon atoms represented by A in the formula (I), linear or branched alkylene groups such as a methylene group, 1,1-ethylene group, dimethylmethylene group, 1,2-ethylene group, propylene group, trimethylene group, tetramethylene group, hexamethylene group, octamethylene group, and decamethylene group; cycloalkylene groups such as a 1,2-cyclobutylene group, 1,3-cyclobutylene group, 1,2-cyclopentylene group, 1,3-cyclopentylene group, 1,2-cyclohexylene group, 1,3-cyclohexylene group, 1,4-cyclohexylene group, 1,2-cycloheptylene group, 1,3-cycloheptylene group, 1,4-cycloheptylene group, 1,2-cyclooctylene group, 1,3-cyclooctylene group, and 1,4-cyclooctylene group; groups originating from bridged hydrocarbons such as adamantane, bicyclo[2.2.1]heptane, bicyclo[2.2.2]octane, tricyclo[5.2.1.0^{2,6}]decane, and tetracyclo[6.2.1.1^{3,6}.0^{2,7}]dodecane; groups originating from aromatic hydrocarbons such as benzene, toluene, ethylbenzene, i-propylbenzene, and naphthalene; and the like can be given.

As examples of the substituents for the divalent hydrocarbon groups represented by A, in addition to acid-dissociable groups producing a carboxyl group, an alcoholic hydroxyl group, or a phenolic hydroxyl group by the action of an acid, a fluorine atom, hydroxyl group, carboxyl group, epoxy group, oxo group, amino group, cyano group, cyanyl group, isocyanyl group, (meth)acryloyl group, (meth)acryloyloxy group, group having a lactonyl group, group having a carboxylic anhydride group, fluoroalkyl group having 1 to 4 carbon atoms, hydroxyalkyl group having 1 to 4 carbon atoms, cyanoalkyl group having 2 to 5 carbon atoms, alkoxyl group having 1-4 carbon atoms, alkoxymethyl group having 2 to 5 carbon atoms, alkoxycarbonyl group having 2 to5 carbon atoms (excluding acid-dissociable groups), alkoxycarbonylamino group having 2 to 5 carbon atoms, alkoxysulfonyl group having 1-4 carbon atoms, and alkylaminosulfonyl group having 1 to 4 carbon atoms can be given.

Any number of one or more types of these substituents may be present in the substitution derivatives.

As A in the formula (I), groups derived from adamantane, bicyclo[2.2.1]heptane, or tetracyclo[6.2.1.1^{3,6}.0^{2,7}]dodecane, and groups obtainable by substituting these groups with a fluorine atom, trifluoromethyl group, or the like are preferable.

As preferable examples of the structural unit (I), units shown by the following formulas (I-1) to (I-5) can be given. 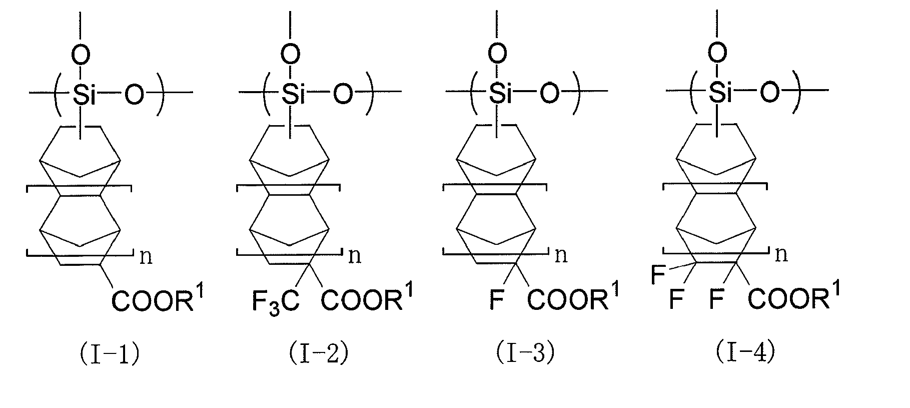 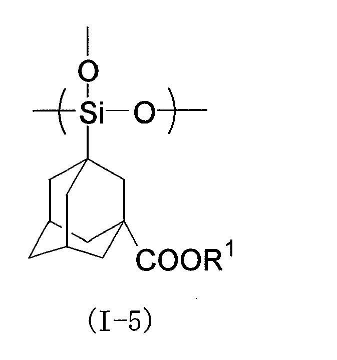 wherein n is 0 or 1 and R¹ is a monovalent acid dissociable group such as groups of the following formulas (1-1) to (1-3), a monovalent cyclic hydrocarbon group having 3 to 20 carbon atoms, a monovalent heterocyclic group having 3 to 20 atoms, a trialkylsilyl group (wherein the carbon atom number of the alkyl group is 1 to 6), or an oxoalkyl group having 4 to 20 carbon atoms.

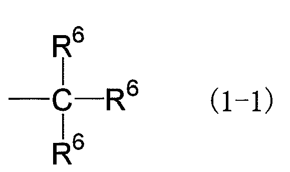

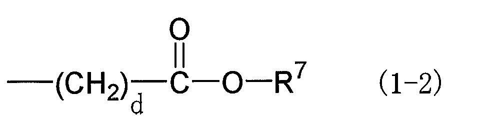

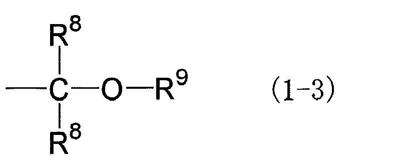

In the formula (1-1), R⁶ individually represents a linear or branched alkyl group having 1 to 4 carbon atoms or a monovalent alicyclic hydrocarbon group having 4 to 20 carbon atoms or a substitution derivative thereof, or any two of R⁶ groups bond together to form a divalent alicyclic hydrocarbon group having 4 to 20 carbon atoms or a substitution derivative thereof, with the remaining R⁶ group being a linear or branched alkyl group having 1 to 4 carbon atoms or a monovalent alicyclic hydrocarbon group having 4 to 20 carbon atoms or a substitution derivative thereof.

In the formula (1-2), R⁷ represents the group of the above formula (1-1), a monovalent cyclic hydrocarbon group having 3 to 20 carbon atoms, a monovalent heterocyclic group having 3 to 20 atoms, a trialkylsilyl group (wherein the carbon atom number is 1 to 6), or an oxoalkyl group having 4 to 20 carbon atoms, and d represents an integer of 0 to 6.

In the formula (1-3), R⁸ individually represents a hydrogen atom or a linear, branched, or cyclic alkyl group having 1 to 20 carbon atoms, R⁹ represents a linear, branched, or cyclic monovalent hydrocarbon group having 1 to 20 carbon atoms or a monovalent heterocyclic group having 3 to 20 carbon atoms, or two R⁸ groups bond together or one of the R⁸ groups bonds with R⁹ to form a ring, wherein the alkyl group represented by R⁸, the monovalent hydrocarbon group or monovalent heterocyclic group represented by R⁹, the ring formed by two R⁸ groups, and the ring formed by R⁸ and R⁹ may be substituted.

As examples of the linear or branched alkyl group having 1 to 4 carbon atoms represented by R⁶ in the formula (1-1), a methyl group, ethyl group, n-propyl group, i-propyl group, n-butyl group, 2-methylpropyl group, 1-methylpropyl group, and t-butyl group can be given.

As examples of the monovalent alicyclic hydrocarbon group having 4 to 20 carbon atoms represented by R⁶ and the divalent alicyclic hydrocarbon group having 4-20 carbon atoms formed by two R⁶ groups in combination, groups derived from a cycloalkane or cycloalkene such as cyclobutane, cyclopentane, cyclopentene, cyclohexane, cyclohexene, cycloheptane, or cyclooctane; groups derived from bridged hydrocarbons such as adamantane, bicyclo[2.2.1]heptane, bicyclo[2.2.2]octane, tricyclo[5.2.1.0^{2,6}]decane, or tetracyclo[6.2.1.1^{3,6} .0^{2,7}]dodecane; and the like can be given.

As examples of the substituents in the substitution derivative of the monovalent or divalent alicyclic hydrocarbon group, the same groups as mentioned for the substituents for divalent hydrocarbon groups represented by A in the formula (I) can be given.

Any number of one or more types of these substituents may be present in the substitution derivatives.

Examples of the groups represented by the formula (1-1) include trialkylmethyl groups such as a t-butyl group, t-amyl group, 2-ethyl-2-butyl group, 3-methyl-3-pentyl group, and 1,1-diethylpropyl group; 1-alkylcycloalkyl groups such as a 1-methylcyclopentyl group, 1-ethylcyclopentyl group, 1-n-propylcyclopentyl group, 1-methylcyclohexyl group, 1-ethylcyclohexyl group, and 1-n-propylcyclohexyl group; alkyl-substituted bridged hydrocarbon groups such as a 2-methyladamantan-2-yl group, 2-methyl-3-hydroxyadamantan-2-yl group, 2-ethyladamantan-2-yl group, 2-ethyl-3-hydroxyadamantan-2-yl group, 2-n-propyladamantan-2-yl group, 2-n-butyladamantan-2-yl group, 2- methoxymethyladamantan-2-yl group, 2-methoxymethyl-3-hydroxyadamantan-2-yl group, 2-ethoxymethyladamantan-2-yl group, 2-n-propoxymethyladamantan-2-yl group, 2-methylbicyclo[2.2.1]heptan-2-yl group, 2-methyl-5-hydroxybicyclo[2.2.1]heptan-2-yl group, 2-methyl-6-hydroxybicyclo[2.2.1]heptan-2-yl group, 2-methyl-5-cyanobicyclo[2.2.1]heptan-2-yl group, 2-methyl-6-cyanobicyclo[2.2.1]heptan-2-yl group, 2-ethylbicyclo[2.2.1]heptan-2-yl group, 2-ethyl-5-hydroxybicyclo[2.2.1]heptan-2-yl group, 2-ethyl-6-hydroxybicyclo[2.2.1]heptan-2-yl group, 8-methyltricyclo[5.2.1.0^{2,6}]decan-8-yl group, 8-methyl-4-hydroxytricyclo[5.2.1.0^{2,6}]decan-8-yl group, 8-methyl-4-cyanotricyclo[5.2.1.0^{2,6}]decan-8-yl group, 8-ethyltricyclo[5.2.1.0^{2,6}]decan-8-yl group, 8-ethyl-4-hydroxytricyclo[5.2.1.0^{2,6}]decan-8-yl group, 4-methyltetracyclo[6.2.1.1^{3,6}.0^{2,7}]dodecan-4-yl group, 4-methyl-9-hydroxytetracyclo[6.2.1.1^{3,6}.0^{2,7}]dodecan-4-yl group, 4-methyl-10-hydroxytetracyclo[6.2.1.1^{3,6}.0^{2,7}]dodecan-4-yl group, 4-methyl-9-cyanotetracyclo[6.2.1.1^{3,6}.0^{2,7}]dodecan-4-yl group, 4-methyl-10-cyanotetracyclo[6.2.1.1^{3,6}.0^{2,7}]dodecan-4-yl group, 4-ethyltetracyclo[6.2.1.1^{3,6}.0^{2,7}]dodecan-4-yl group, 4-ethyl-9-hydroxytetracyclo[6.2.1.1^{3,6}.0^{2,7}]dodecan-4-yl group, and 4-ethyl-10-hydroxytetracyclo[6.2.1.1^{3,6}.0^{2,7}]dodecan-4-yl group; dialkylcycloalkylmethyl groups such as a 1-methyl-1-cyclopentylethyl group, 1-methyl-1-(2-hydroxycyclopentyl)ethyl group, 1-methyl-1-(3-hydroxycyclopentyl)ethyl group, 1-methyl-1-cyclohexylethyl group, 1-methyl-1-(3-hydroxycyclohexyl)ethyl group, 1-methyl-1-(4-hydroxycyclohexyl)ethyl group, 1-methyl-1-cycloheptylethyl group, 1-methyl-1-(3-hydroxycycloheptyl)ethyl group, and 1-methyl-1-(4-hydroxycycloheptyl)ethyl group; alkyl-substituted bridged hydrocarbon group-substituted methyl groups such as a 1-methyl-1-(adamantan-1-yl)ethyl group, 1-methyl-1-(3-hydroxyadamantan-1-yl)ethyl group, 1-methyl-1-(bicyclo[2.2.1]heptan-2-yl)ethyl group, 1-methyl-1-(5-hydroxybicyclo[2.2.1]heptan-2-yl)ethyl group, 1-methyl-1-(6-hydroxybicyclo[2.2.1]heptan-2-yl)ethyl group, 1-methyl-1-(tetracyclo[6.2.1.1^{3,6}.0^{2,7}]dodecan-4-yl)ethyl group, 1-methyl-1-(9-hydroxytetracydo[6.2.1.1^{3,6}.0^{2,7}]dodecan-4-yl)ethyl group, 1-methyl-1-(10-hydroxytetracyclo[6.2.1.1^{3,6}.0^{2,7}]dodecan-4-yl)ethyl group, 1-methyl-1-(tricyclo[5.2.1.0^{2,6}]decan-8-yl)ethyl group, and 1-methyl-1-(4-hydroxytricyclo[5.2.1.0^{2,6}]decan-8-yl)ethyl group; alkyldicycloalkylmethyl groups such as a 1,1-dicyclopentylethyl group, 1,1-di(2-hydroxycyclopentyl)ethyl group, 1,1-di(3-hydroxycyclopentyl)ethyl group, 1,1-dicyclohexylethyl group, 1,1-di(3-hydroxycyclohexyl)ethyl group, 1,1-di(4-hydroxycyclohexyl)ethyl group, 1,1-dicycloheptylethyl group, 1,1-di(3-hydroxycycloheptyl)ethyl group, and 1,1-di(4-hydroxycycloheptyl)ethyl group; alkyl-substituted di(bridged hydrocarbon group)-substituted methyl groups such as a 1,1-di(adamantan-1-yl)ethyl group, 1,1-di-(3-hydroxyadamantan-1-yl)ethyl group, 1,1-di(bicyclo[2.2.1]heptan-2-yl)ethyl group, 1,1 -di(5-hydroxybicyclo[2.2.1]heptan-2-yl)ethyl group, 1,1-di(6-hydroxybicyclo[2.2.1]heptan-2-yl)ethyl group, 1,1-di(tetracydo[6.2.1.1^{3,6}.0^{2,7}]dodecan-4-yl)ethyl group, 1,1-di(9-hydroxytetracyclo[6.2.1.1^{3,6}.0^{2,7}]dodecan-4-yl)ethyl group, 1,1-di(10-hydroxytetracyclo[6.2.1.1^{3,6}.0^{2,7}]dodecan-4-yl)ethyl group, 1,1-di(tricyclo[5.2.1.0^{2,6}]decan-8-yl)ethyl group, and 1,1-di(4-hydroxytricyclo[5.2.1.0^{2,6}]decan-8-yl)ethyl group; and the like.

As examples of the monovalent cyclic hydrocarbon group having 3 to 20 carbon atoms represented by R⁷ in the formula (1-2), a cyclobutyl group, cyclopentyl group, cyclopentenyl group, cyclohexyl group, cyclohexenyl group, cycloheptyl group, cyclooctyl group, adamantan-1-yl group, bicyclo[2.2.1]heptan-2-yl group, bicyclo[2.2.2]octyl group, tricyclo[5.2.1.0^{2,6}]decan-3-yl group, and tetracyclo[6.2.1.1^{3,6}.0^{2,7}]dodecan-4-yl group can be given.

As examples of the monovalent heterocyclic group having 3 to 20 atoms represented by R⁷, a 2-tetrahydrofuranyl group and 2-tetrahydropyranyl group can be given.

As examples of the trialkylsilyl group represented by R⁷, a trimethylsilyl group, ethyldimethylsilyl group, methyldiethylsilyl group, triethylsilyl group, i-propyldimethylsilyl group, methyldi-i-propylsilyl group, tri-i-propylsilyl group, and t-butyldimethylsilyl group can be given.

As examples of the oxoalkyl group having 4-20 carbon atoms represented by R⁷, a 3-oxocyclopentyl group, 3-oxocyclohexyl group, 4-oxocyclohexyl group, 4-methyl-2-oxooxan-4-yl group, and 5-methyl-2-oxooxolan-5-yl group can be given.

Examples of the groups represented by the formula (1-2) include a t-butoxycarbonyl group, t-amyloxycarbonyl group, 1,1-diethylpropoxycarbonyl group, 1-methylcyclopentyloxycarbonyl group, 1-ethylcyclopentyloxycarbonyl group, 1-methylcyclohexyloxycarbonyl group, 1-ethylcyclohexyloxycarbonyl group, 1-methyl-2-cyclopentenyloxycarbonyl group, 1-ethyl-2-cyclopentenyloxycarbonyl group, (2-methyladamantan-2-yl)oxycarbonyl group, (2-ethyladamantan-2-yl)oxycarbonyl group, (2-methylbicyclo[2.2.1]heptan-2-yl)oxycarbonyl group, (2-ethylbicyclo[2.2.1]heptan-2-yl)oxycarbonyl group, t-butoxycarbonylmethyl group, t-amyloxycarbonylmethyl group, 1,1-diethylpropoxycarbonylmethyl group, 1-methylcyclopentyloxycarbonylmethyl group, 1-ethylcyclopentyloxycarbonylmethyl group, 1-methylcyclohexyloxycarbonylmethyl group, 1-ethylcyclohexyloxycarbonylmethyl group, 1-methyl-2-cyclopentenyloxycarbonylmethyl group, 1-ethyl-2-cyclopentenyloxycarbonylmethyl group, (2-methyladamantan-2-yl)oxycarbonylmethyl group, (2-ethyladamantan-2-yl)oxycarbonylmethyl group, (2-methylbicyclo[2.2.1]heptan-2-yl)oxycarbonylmethyl group, (2-ethylbicyclo[2.2.1]heptan-2-yl)oxycarbonylmethyl group, 2-tetrahydrofuranyloxycarbonylmethyl group, 2-tetrahydropyranyloxycarbonylmethyl group, 1-methoxyethoxycarbonylmethyl group, 1-ethoxyethoxycarbonylmethyl group, (1-methyl-1-cyclopentylethoxy)carbonylmethyl group, (1-methyl-1-cyclohexylethoxy)carbonylmethyl group, [1-methyl-1-(adamantan-1-yl)ethoxy]carbonylmethyl group, [1-methyl-1-(bicyclo[2.2.1] heptan-2-yl)ethoxy]carbonylmethyl group, 2-tetrahydrofuranyloxycarbonylmethyl group, and 2-tetrahydropyranyloxycarbonylmethyl group.

In the formula (1-3), as examples of the linear, branched, or cyclic alkyl group having 1 to 20 carbon atoms represented by R⁸, a methyl group, ethyl group, n-propyl group, i-propyl group, n-butyl group, 2-methylpropyl group, 1-methylpropyl group, t-butyl group, n-pentyl group, neopentyl group, n-hexyl group, n-heptyl group, n-octyl group, 2-ethylhexyl group, n-nonyl group, n-decyl group, cyclobutyl group, cyclopentyl group, cyclohexyl group, cycloheptyl group, and cyclooctyl group can be given.

As examples of the linear, branched, or cyclic monovalent hydrocarbon group having 1 to 20 carbon atoms represented by R⁹ in the formula (1-3), linear or branched alkyl groups such as a methyl group, ethyl group, n-propyl group, i-propyl group, n-butyl group, 2-methylpropyl group, 1-methylpropyl group, t-butyl group, n-pentyl group, neopentyl group, n-hexyl group, n-heptyl group, n-octyl group, 2-ethylhexyl group, n-nonyl group, and n-decyl group; cycloalkyl groups such as a cyclobutyl group, cyclopentyl group, cyclohexyl group, cycloheptyl group, and cyclooctyl group; groups originating from bridged hydrocarbons such as an adamantan-1-yl group, adamantan-2-yl group, bicyclo[2.2.1]heptan-2-yl group, bicyclo[2.2.2]octan-2-yl group, tricyclo[5.2.1.0^{2,6}]decan-3-yl group, and tetracyclo[6.2.1.1^{3,6}.0^{2,7}]dodecan-4-yl group; aryl groups such as a phenyl group, o-tolyl group, m-tolyl group, p-tolyl group, 1-naphthyl group, and 2-naphthyl group; aralkyl groups such as a benzyl group, α-methylbenzyl group, α,α-dimethylbenzyl group, and phenethyl group; and the like can be given.

As examples of the monovalent heterocyclic group having 3 to 20 atoms represented by R⁹, groups originating from nonbridged heterocyclic compounds such as oxetane, thietane, tetrahydrofurane, tetrahydrothiofurane, tetrahydropyrane, or tetrahydrothiopyrane, and groups originating from bridged heterocyclic compounds such as compounds shown by the following formulas (1-3-1) to (1-3-4) can be given.

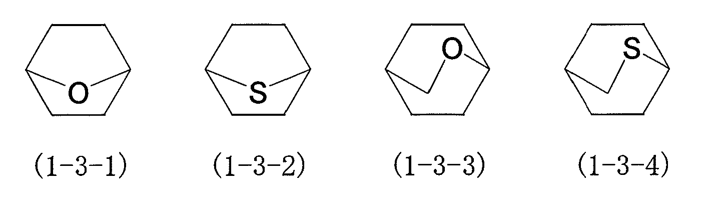

As examples of the ring formed by bonding of the two R⁸ groups, 3 to 8 member rings formed with the carbon atoms to which the two R⁸ groups bond can be given.

As examples of the ring formed by bonding of the one of the R⁸ groups and R⁹, 3 to 8 member rings formed with the carbon atom to which the R⁸ group bonds and the oxygen atom to which the R⁹ group bonds can be given.

As examples of the substituents for the alkyl group represented by R⁸, the monovalent hydrocarbon group and monovalent heterocyclic group represented by R⁹, the ring formed from mutual bonding of the two R⁸ groups, and the ring formed by bonding of one of the R⁸ groups with the R⁹ group, the same groups previously given as the substituents for the divalent hydrocarbon groups represented by A in the formula (I) can be given.

Any number of one or more types of these substituents may be present in the substitution derivatives.

As preferable specific examples of the substituted monovalent hydrocarbon group or substituted monovalent heterocyclic group represented by R⁹ in the formula (1-3), a 4-hydroxy-n-butyl group, 6-hydroxy-n-hexyl group, 2-n-butoxyethyl group, 2-(2-hydroxyethoxy)ethyl group, (4-hydroxymethylcyclohexyl)methyl group, and the groups of the following formulas (1-3-5) to (1-3-8) can be given.

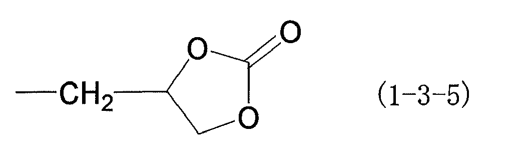

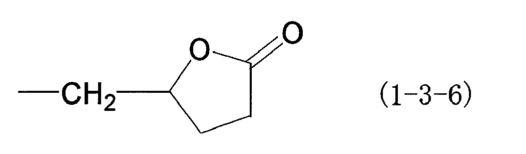

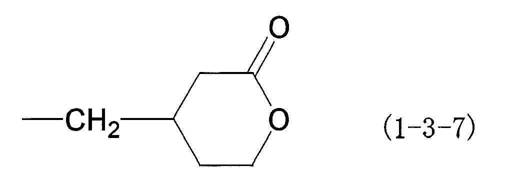

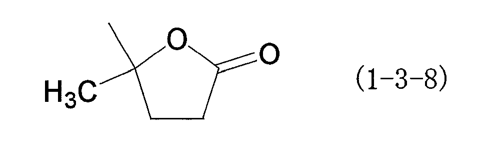

Examples of the groups represented by the formula (1-3) include substituted methyl groups such as a methoxymethyl group, ethoxymethyl group, n-propoxymethyl group, i-propoxymethyl group, n-butoxymethyl group, t-butoxymethyl group, cyclopentyloxymethyl group, cyclohexyloxymethyl group, phenoxymethyl group, benzyloxymethyl group, and phenethyloxymethyl group; 1-substituted ethyl groups such as a 1-methoxyethyl group, 1-ethoxyethyl group, 1-n-propoxyethyl group, 1-i-propoxyethyl group, 1-n-butoxyethyl group, 1-t-butoxyethyl group, 1-cyclopentyloxyethyl group, 1-cyclohexyloxyethyl group, 1-phenoxyethyl group, 1-benzyloxyethyl group, and 1-phenethyloxyethyl group; 1-methyl-1-substituted ethyl groups such as a 1-methyl-1-methoxyethyl group, 1-methyl-1-ethoxyethyl group, 1-methyl-1-n-propoxyethyl group, 1-methyl-1-i-propoxyethyl group, 1-methyl-1-n-butoxyethyl group, 1-methyl-1-t-butoxyethyl group, 1-methyl-1-cyclopentyloxyethyl group, 1-methyl-1-cyclohexyloxyethyl group, 1-methyl-1-phenoxyethyl group, 1-methyl-1-benzyloxyethyl group, and 1-methyl-1-phenethyloxyethyl group; 1-substituted-n-propyl groups such as a 1-methoxy-n-propyl group, 1-ethoxy-n-propyl group, 1-n-propoxy-n-propyl group, and 1-phenoxy-n-propyl group; 2-substituted-n-propyl groups such as a 2-methoxy-n-propyl group, 2-ethoxy-n-propyl group, 2-n-propoxy-n-propyl group, and 2-phenoxy-n-propyl group; 1-substituted-n-butyl groups such as a 1-methoxy-n-butyl group, 1-ethoxy-n-butyl group, 1-n-propoxy-n-butyl group, and 1-phenoxy-n-butyl group; and heterocyclic group such as tetrahydrofuran-2-yl group, 2-methyltetrahydrofuran-2-yl group, tetrahydropyran-2-yl group, and 2-methyltetrahydropyran-2-yl group.

As examples of the monovalent cyclic hydrocarbon groups having 3 to 20 carbon atoms represented by R¹ in the formula (I), the same groups as previously mentioned in connection with the monovalent cyclic hydrocarbon groups having 3 to 20 carbon atoms represented by R⁷ in the formula (1-2) can be given.

As examples of the monovalent heterocyclic groups having 3 to 20 atoms represented by R¹, the same groups as previously mentioned in connection with the monovalent heterocyclic groups having 3 to 20 atoms represented by R⁷ in the formula (1-2) can be given.

As examples of the trialkylsilyl groups represented by R¹, the same groups as previously mentioned in connection with the trialkylsilyl groups represented by R⁷ in the formula (1-2) can be given.

As examples of the oxoalkyl groups having 4 to 20 carbon atoms represented by R¹, the same groups as previously mentioned in connection with the oxoalkyl groups having 4 to 20 carbon atoms represented by R⁷ in the formula (1-2) can be given.

Of these monovalent acid-dissociable groups represented by R¹, the groups shown by the formulas (1-1) and (1-2) are preferable, with particularly preferable groups being a t-butyl group, 1-methylcyclopentyl group, 1-ethylcyclopentyl group, 1-methylcyclohexyl group, 1-ethylcyclohexyl group, 2-methyladamantyl group, 2-ethyladamantyl group, t-butoxycarbonylmethyl group, and the like.

The structural unit (I) may be used in the siloxane resin (α) either individually or in combination of two or more.

As examples of the divalent linear, branched, or cyclic hydrocarbon groups having 1 to 20 carbon atoms represented by B in the formula (II), in addition to the same divalent linear, branched, or cyclic hydrocarbon groups having 1 to 20 carbon atoms as those previously given for the group A in the formula (I), divalent cyclic hydrocarbon groups substituted with a linear or branched alkyl groups having 1 to 20 carbon atoms can be given.

As examples of the substituents for the divalent hydrocarbon groups represented by B, among the substituents for the divalent linear, branched, or cyclic hydrocarbon groups having 1 to 20 carbon atoms previously given for the group A in the formula (I), those not containing a fluorine atom can be given.

As B in the formula (II), a methylene group, 1,2-ethylene group, propylene group, trimethylene group, tetramethylene group, and hexamethylene group, 1,4-cyclohexylene group; groups derived from adamantane, bicyclo[2.2.1]heptane, or tetracyclo[6.2.1.1^{3,6}.0^{2,7}]dodecane; and groups obtainable by substituting a 1,4-cyclohexylene group or groups derived from cyclohexane, adamantane, bicyclo[2.2.1]heptane, or tetracyclo[6.2.1.1^{3,6}.0^{2,7}]dodecane with a linear or a branched alkyl group having 1 to 20 carbon atoms; and the like are preferable.

As preferable examples of the structural unit (II), units shown by the following formulas (II-1) to (II-6) can be given, provided that the units shown by the formulas (II-4) to (II-6) may be substituted with a linear or branched alkyl group having 1 to 20 carbon atoms.

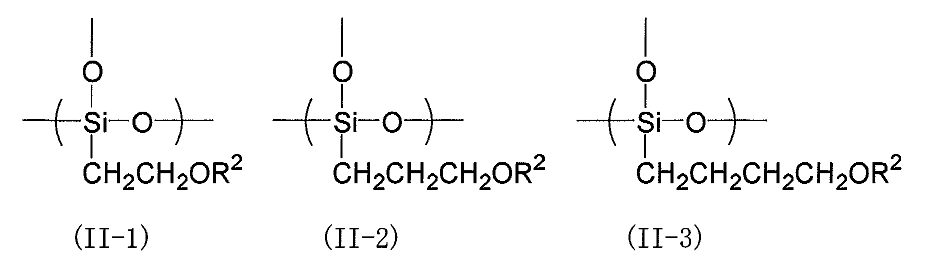

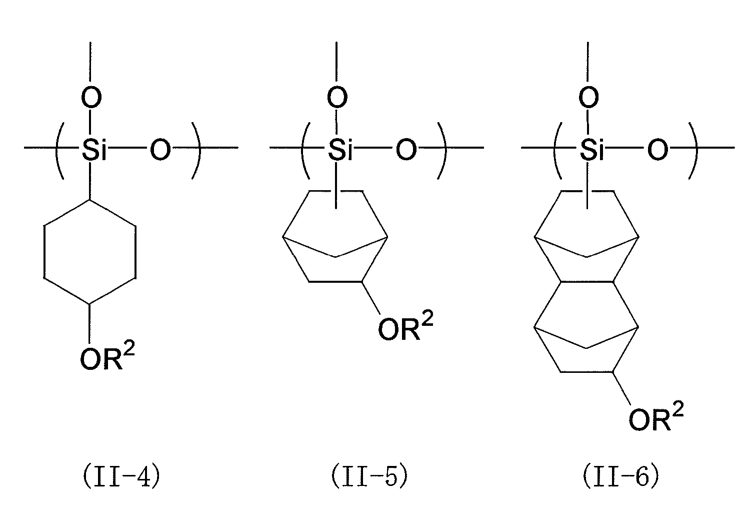

As examples of the linear, branched, or cyclic alkyl groups having 1 to 20 carbon atoms of R² in the formula (II), the same linear, branched, or cyclic alkyl groups having 1 to 20 carbon atoms as those previously given for the group R⁸ in the formula (1-3) can be given.

As examples of the substituents for the alkyl groups for R², the same substituents as mentioned for the divalent linear, branched, or cyclic hydrocarbon groups having 1 to 20 carbon atoms for A in the formula (I) can be given.

As R² in the formula (II), a methyl group, ethyl group, n-propyl group, i-propyl group, n-butyl group, t-butyl group, n-pentyl group, n-hexyl group, and the like are preferable.

The structural unit (II) may be used in the siloxane resin (α) either individually or in combination of two or more.

The amount of the structural unit (I) in the siloxane resin (α) is more than 0 mol% but not more than 70 mol%, preferably 10 to 60 mol%, and particularly preferably 15 to 50 mol% of the total amount of the structural units, whereas the amount of the structural unit (II) is more than 0 mol% but not more than 70 mol%, preferably 1 to 50 mol%, and particularly preferably 2 to 30 mol% of the total amount of the structural units. If the content of the structural unit (I) is 0 mol%, resist pattern formation tends to be difficult. If the content is more than 70 mol%, on the other hand, the effect of development defect improvement tends to decrease. If the amount of the structural unit (II) is 0 mol%, the effect of development defect improvement tends to decrease. If the content is more than 70 mol%, on the other hand, the rate of residual film tends to decrease.

The siloxane resin (α) may further contain a structural unit (III) shown by the following formula (III) and/or a structural unit (IV) shown by the following formula (IV) in the same molecule.

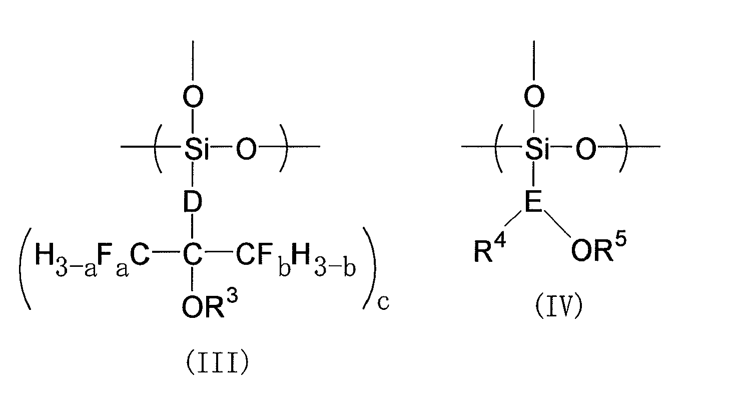

In the formula (III), D represents a substituted or unsubstituted, linear or branched hydrocarbon group having 1 to 20 carbon atoms with a valence of (c+1) or a substituted or unsubstituted alicyclic hydrocarbon group having 3 to 20 carbon atoms with a valence of (c+1), R³ represents a hydrogen atom or a monovalent acid dissociable group, a and b are individually an integer of 0 to 3 satisfying the formula (a + b) ≥ 1, and C is an integer of 1 to 3.

In the formula (IV), E represents a substituted or unsubstituted trivalent alicyclic hydrocarbon group having 3 to 20 carbon atoms or a substituted or unsubstituted trivalent heterocyclic group having 3 to 20 atoms, R⁴ represents a fluorine atom or a linear or branched fluoroalkyl group having 1 to 4 carbon atoms, and R⁵ represents a hydrogen atom or monovalent acid-dissociable group.

In the formula (III), as examples of the linear or branched hydrocarbon group having 1-20 carbon atoms with a valence of (c + 1) represented by D, groups derived from a linear or branched alkane such as methane, ethane, propane, n-butane, i-butane, n-pentane, i-pentane, neopentane, n-hexane, i-hexane, n-octane, 2-ethylhexane, n-decane, or the like can be given.

As examples of the alicyclic hydrocarbon group having 3 to 20 carbon atoms with a valence of (c + 1) represented by D, groups originating from cycloalkanes such as cyclobutane, cyclopentane, cyclohexane, cycloheptane, and cyclooctane; groups originating from a bridged hydrocarbon such as adamantane, bicyclo[2.2.1]heptane, bicyclo[2.2.2]octane, tricyclo[5.2.1.0^{2,6}]decane, and tetracyclo[6.2.1.1^{3,6}.0^{2,7}]dodecane; groups obtainable by bonding of a methylene group or an alkylene group having 2 to 4 carbon atoms in the main chain (e.g. 1,1-ethylene group, 1-methyl-1,1-ethylene group, etc.) to the above group originating from a bridged hydrocarbon; and the like can be given.

As examples of the substituents for the linear or branched hydrocarbon groups with a valence of (c + 1) or the alicyclic hydrocarbon group having 3 to 20 atoms with a valence of (c + 1) represented by D, the same groups as those mentioned as examples of the substituent for the divalent hydrocarbon group represented by A in the formula (I) can be given.

Any number of one or more types of these substituents may be present in the substitution derivatives.

As D in the formula (III), groups originating from adamantane, bicyclo[2.2.1]heptane, or tetracyclo[6.2.1.1^{3,6}.0^{2,7}]dodecane, groups obtainable by bonding a methylene group or an alkylene group having 2 to 4 carbon atoms in the main chain (e.g. 1,1-ethylene group, 1-methyl-1,1-ethylene group, etc.) to the above groups, and the like are preferable.

6 is particularly preferable as (a + b), and 1 is particularly preferable as c.

As specific examples of the structural unit (III), units shown by the following formulas (III-1) to (III-5) can be given.

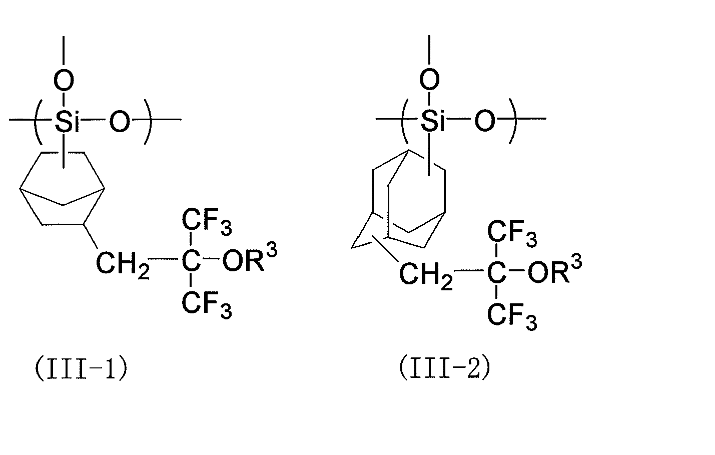

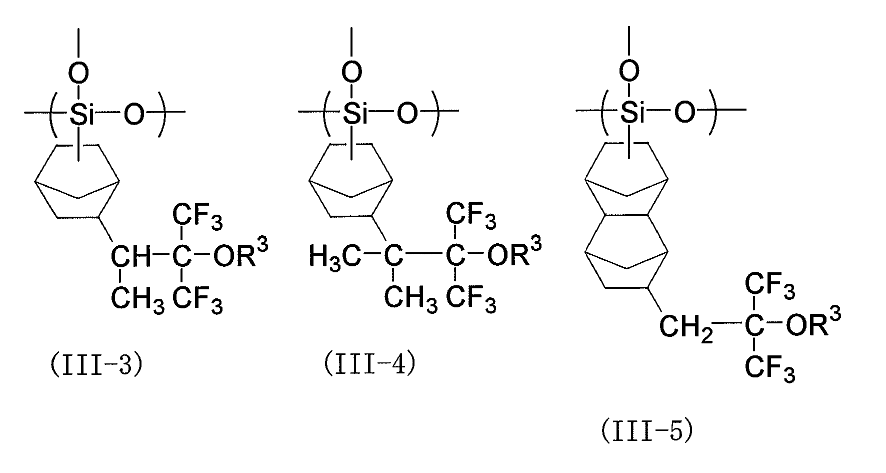

As examples of the monovalent acid dissociable group represented by R³ in the formula (III), the same groups as those previously given for the monovalent acid dissociable group R¹ in the formula (1) can be given.

As R³ in the formula (III), a hydrogen atom, methoxymethyl group, ethoxymethyl group, t-butoxycarbonyl group, and the like are preferable.

As examples of the trivalent alicyclic hydrocarbon group having 3 to 20 carbon atoms represented by E in the formula (IV), groups derived from a cycloalkane such as cyclobutane, cyclopentane, cyclohexane, cycloheptane, or cyclooctane; groups derived from a bridged hydrocarbon such as adamantane, bicyclo[2.2.1]heptane, bicyclo[2.2.2]octane, tricyclo[5.2.1.0^{2,6}]decane, or tetracyclo[6.2.1.1^{3,6}.0^{2,7}]dodecane; and groups obtainable by bonding of a methylene group or an alkylene group having 2 to 4 carbon atoms in the main chain (e.g. 1,1-ethylene group, 1-methyl-1,1-ethylene group, etc.) to the above groups derived from a bridged hydrocarbon, and the like can be given.

As examples of the trivalent heterocyclic group having 3 to 20 atoms represented by E, groups originating from nonbridged heterocyclic compounds such as tetrahydrofurane, tetrahydrothiofurane, tetrahydropyrane, or tetrahydrothiopyrane, and groups originating from a bridged heterocyclic compound such as compounds shown by the above formulas (1-3-1) to (1-3-4) can be given.

As examples of the substituent for the above trivalent alicyclic hydrocarbon group and trivalent heterocyclic group represented by E, the same groups as mentioned for the substituents for divalent hydrocarbon groups represented by A in the formula (I) can be given.

Any number of one or more types of these substituents may be present in the substitution derivatives.

As E in the formula (IV), groups originating from adamantane, bicyclo[2.2.1]heptane, or tetracyclo[6.2.1.1^{3,6}.0^{2,7}]dodecane, groups obtainable by bonding a methylene group or an alkylene group having 2 to 4 carbon atoms in the main chain (e.g. 1,1-ethylene group, 1-methyl-1,1-ethylene group, etc.) to the above groups, and the like are preferable.

As specific examples of the structural unit (IV), units shown by the following formulas (IV-1) to (IV-7) can be given.

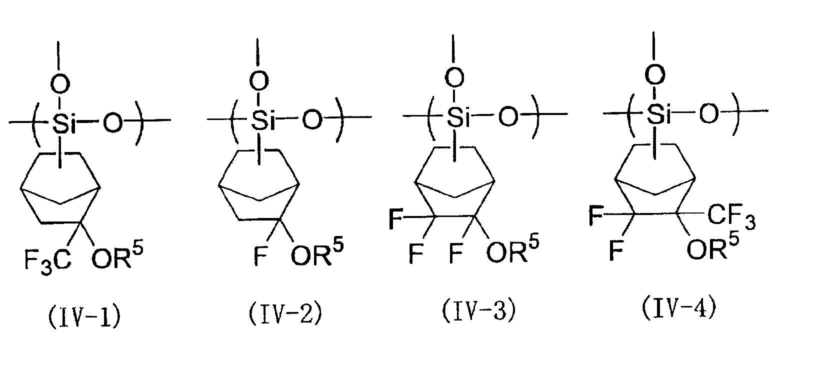

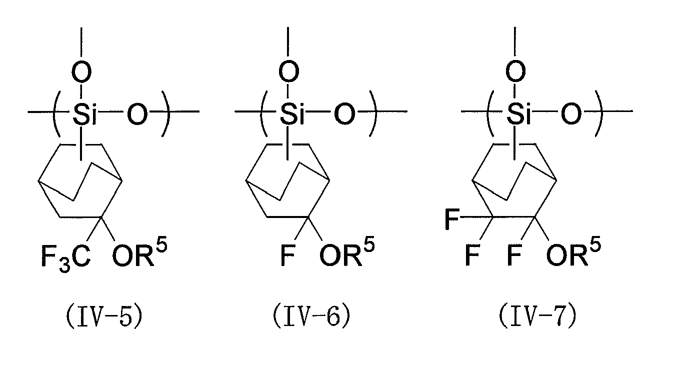

As examples of the linear or branched fluoroalkyl group having 1 to 4 carbon atoms represented by R⁴ in the formula (IV), a fluoromethyl group, trifluoromethyl group, 2,2,2-trifluoroethyl group, pentafluoroethyl group, 3,3,3-trifluoro-n-propyl group, 3,3,3,2,2-pentafluoro-n-propyl group, heptafluoro-n-propyl group, 4,4,4-trifluoro-n-butyl group, 4,4,4,3,3-pentafluoro-n-butyl group, 4,4,4,3,3,2,2-heptafluoro-n-butyl group, and nonafluoro-n-butyl group can be given.

As the group R⁴ in the formula (IV), a fluorine atom, a trifluoromethyl group, and the like are preferable. As examples of the monovalent acid dissociable group represented by R⁵ in the formula (IV), the same groups as those previously given for the monovalent acid dissociable group R¹ in the formula (1) can be given.

As R⁵ in the formula (IV), a hydrogen atom, methoxymethyl group, ethoxymethyl group, t-butoxycarbonyl group, and the like are preferable.

When the siloxane resin (a) has the structural unit (III) and/or the structural unit (IV), structural unit (III) and the structural unit (IV) may be present either individually or in combination of two or more.

When the siloxane resin (α) has the structural unit (III) and/or the structural unit (IV), the amount of the structural unit (I) is more than 0 mol% but not more than 70 mol%, preferably 10 to 60 mol%, and particularly preferably 15 to 50 mol%, the amount of the structural unit (II) is more than 0 mol% but not more than 70 mol%, preferably 1 to 50 mol%, and particularly preferably 2 to 30 mol%, and the total amount of the structural unit (III) and the structural unit (IV) is more than 0 mol% but not more than 70 mol%, preferably 1 to 50 mol%, and particularly preferably 2 to 30 mol%. If the amount of the structural unit (I) is 0 mol%, resolution tends to decrease; if more than 70 mol%, the effect of development defect improvement tends to decrease. If the amount of the structural unit (II) is 0 mol%, the effect of development defect improvement tends to decrease. If the content is more than 70 mol%, on the other hand, the rate of residual film tends to decrease. If the total amount of the structural unit (III) and structural unit (IV) is 0 mol%, the sensitivity tends to decrease; if more than 70 mol%, on the other hand, the rate of residual film tends to decrease. The siloxane resin (α) may further have one or more structural units other than the above structural units originating from a silane compound with tri-functionality in regard to a condensation reaction, such as a structural unit shown by the following formula (V), and one or more structural units originating from a silane compound with di- or tetra-functionality in regard to a condensation reaction. 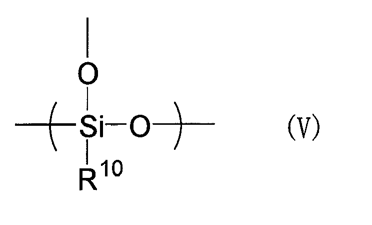 wherein R¹⁰ represents a substituted or unsubstituted monovalent hydrocarbon group having 1 to 20 carbon atoms or a substituted or unsubstituted monovalent heterocyclic group having 3 to 20 atoms.

As examples of the monovalent hydrocarbon group having 1 to 20 carbon atoms represented by R¹⁰ in the formula (V), linear or branched alkyl groups such as a methyl group, ethyl group, n-propyl group, i-propyl group, n-butyl group, 2-methylpropyl group, 1-methylpropyl group, t-butyl group, n-pentyl group, neopentyl group, n-hexyl group, n-heptyl group, n-octyl group, 2-ethylhexyl group, n-nonyl group, and n-decyl group; cycloalkyl groups such as a cyclobutyl group, cyclopentyl group, cyclohexyl group, cycloheptyl group, and cyclooctyl group; groups originating from bridged hydrocarbons such as an adamantan-1-yl group, adamantan-2-yl group, bicyclo[2.2.1]heptan-2-yl group, bicyclo[2.2.2]octan-2-yl group, tricyclo[5.2.1.0^{2,6}]decan-3-yl group, and tetracyclo[6.2.1.1^{3,6}.0^{2,7}]dodecan-4-yl group; aryl groups such as a phenyl group, o-tolyl group, m-tolyl group, p-tolyl group, 1-naphthyl group, and 2-naphthyl group; aralkyl groups such as a benzyl group, α-methylbenzyl group, α,α-dimethylbenzyl group, and phenethyl group; and the like can be given.

As examples of the monovalent heterocyclic group having 3 to 20 atoms represented by R¹⁰, groups originating from nonbridged heterocyclic compounds such as oxetane, thietane, tetrahydrofurane, tetrahydrothiofurane, tetrahydropyrane, or tetrahydrothiopyrane, and groups originating from a bridged heterocyclic compound such as compounds shown by the above formulas (1-3-1) to (1-3-4) can be given.

As examples of the substituent for the above monovalent hydrocarbon group and monovalent heterocyclic group of R¹⁰, the same groups as mentioned for the substituents for the divalent hydrocarbon group represented by A in the formula (I) can be given.

Any number of one or more types of these substituents may be present in the substitution derivatives.

The siloxane resin (α) may be cross-linked intra-molecularly and/or inter-molecularly by an acid dissociable coupling group shown by the following formula (2-1) or (2-2). 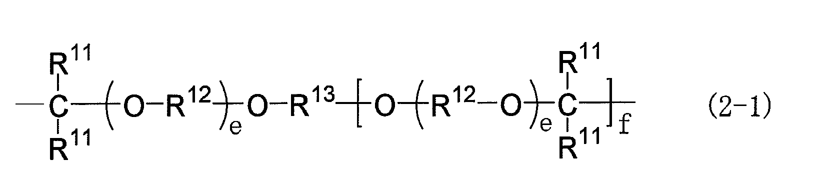 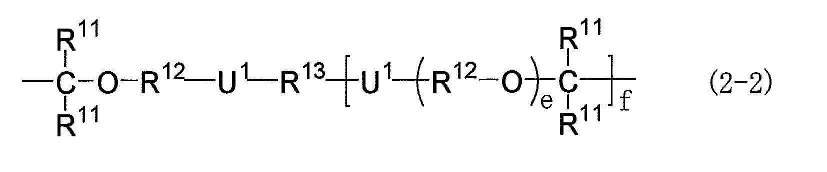 wherein R¹¹ individually represents a hydrogen atom or a linear, branched, or cyclic alkyl group having 1 to 8 carbon atoms, or two R¹¹ groups bonding to the same carbon atom bonds together to form a 3 to 8 member carbon ring, R¹² individually represents a methylene group or a linear, branched, or cyclic alkylene group having 2 to 10 carbon atoms, e individually represents an integer of 0 to 10, f individually represents an integer of 1 to 7, R¹³ individually represents a linear or branched saturated hydrocarbon group having 1 to 50 carbon atoms with a valence of (f + 1), a saturated cyclic hydrocarbon group having 3 to 50 carbon atoms with a valence of (f + 1), an aromatic hydrocarbon group having 6 to 50 carbon atoms with a valence of (f + 1), or a heterocyclic group having 3 to 50 atoms with a valence of (f + 1), wherein the linear or branched saturated hydrocarbon group, saturated cyclic hydrocarbon group, aromatic hydrocarbon group, and heterocyclic group have a hetero atom in the main chain and/or the side chain and at least a part of the hydrogen atoms bonding to the carbon atoms may be replaced with a fluorine atom, hydroxyl group, carboxyl group, or acyl group, and U¹ individually represents -COO-, -NHCOO-, or -NHCONH-.

Specific preferable examples of the acid-dissociable coupling groups include the groups of the following formulas (2-1-1) to (2-1-8).

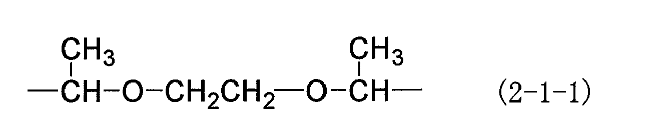

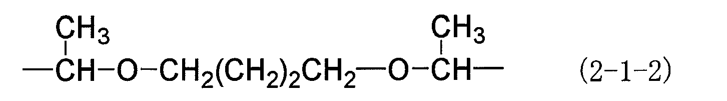

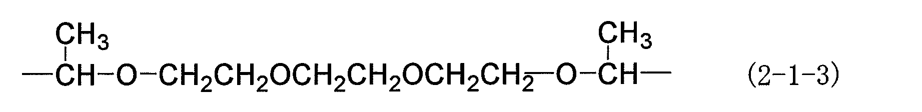

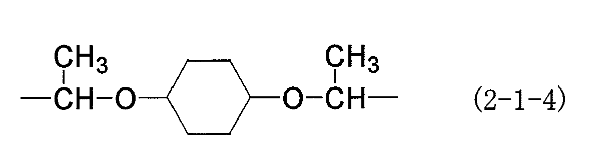

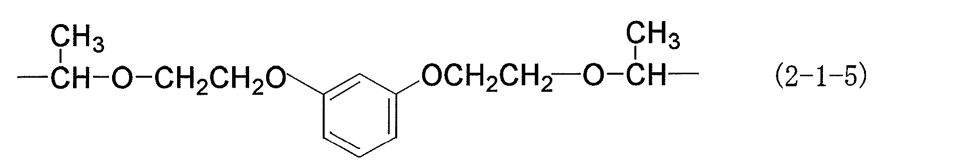

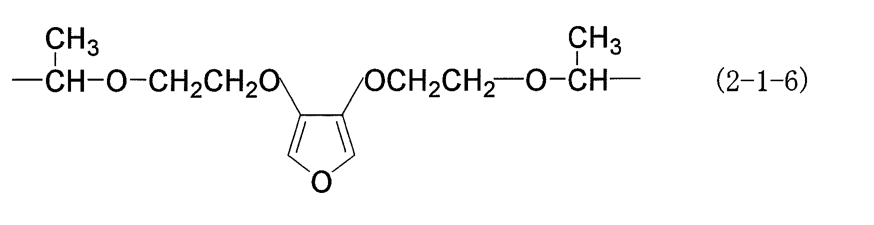

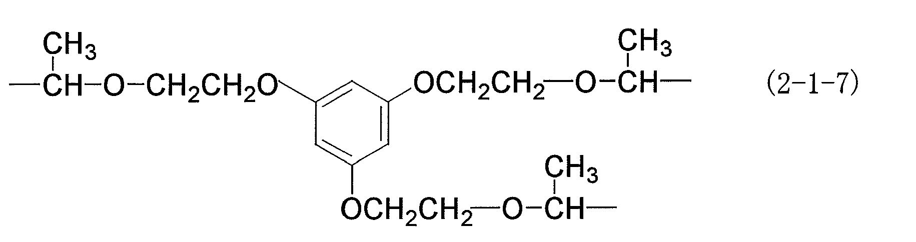

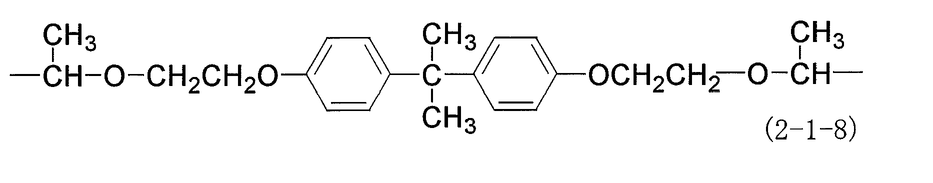

The polystyrene-reduced weight average molecular weight (hereinafter referred to as "Mw") of the siloxane resin (α) determined by gel permeation chromatography (GPC) is 500 to 1,000,000, preferably 5,000 to 100,000, and particularly preferably 500 to 40,000. If the Mw of the siloxane resin (a) is less than 500, the glass transition temperature of the resin tends to decrease. If the Mw exceeds 1,000,000, solubility of the resin in solvents tends to decrease.

### <Preparation of siloxane resin (α)>

The siloxane resin (α) in which the acid dissociable group has not been dissociated can be prepared by polycondensation of condensable silane compounds corresponding to each structural unit (for example, a trichlorosilane compound, triethoxysilane compound, etc.).

The siloxane resin (α) in which the acid dissociable group dissociated can be prepared by polycondensation of condensable silane compounds corresponding to each structural unit, after protecting a carboxyl group, an alcoholic hydroxyl group, or a phenolic hydroxyl group with an acetyl group, a lower alkyl group (for example, a methyl group, an ethyl group, etc.), and the like, followed by dissociation of the acetyl group or lower alkyl group.

The siloxane resin (α) having an acid dissociable group can also be prepared by introducing an acid dissociable group into the carboxyl group, alcoholic hydroxyl group, or phenolic hydroxyl group of the siloxane resin (α) in which the acid dissociable group dissociated.

The method for preparing the siloxane resin (α) and the method for synthesizing a condensable silane compound used for preparing the siloxane resin (α) are also described in Patent Documents 6 to 8, for example.
Patent document 6: JP-A-2002-268225
Patent document 7: JP-A-2002-268226
Patent document 8: JP-A-2002-268227

Although condensable silane compounds for producing the siloxane resin (α) can be polycondensed in the presence of an acidic catalyst or a basic catalyst in a solvent or without using a solvent, the polycondensation is preferably conducted in the presence of an acidic catalyst or, preferably, after polycondensation in the presence of an acidic catalyst, the reaction is continued in the presence of a basic catalyst in the present invention.

The polycondensation method for producing the siloxane resin (α) will now be described.

As examples of the acidic catalyst, hydrochloric acid, sulfuric acid, nitric acid, formic acid, acetic acid, n-propionic acid, butyric acid, valeric acid, oxalic acid, malonic acid, succinic acid, maleic acid, fumaric acid, adipic acid, phthalic acid, terephthalic acid, acetic anhydride, maleic anhydride, citric acid, boric acid, phosphoric acid, titanium tetrachloride, zinc chloride, aluminum chloride, benzenesulfonic acid, p-toluenesulfonic acid, and methanesulfonic acid can be given.

Of these acidic catalysts, hydrochloric acid, sulfuric acid, acetic acid, oxalic acid, malonic acid, maleic acid, fumaric acid, acetic anhydride, maleic anhydride, and the like are preferable.

These acidic catalysts may be used either individually or in combination of two or more.

The acidic catalysts are usually used in the amount of 0.01 to 10,000 parts by weight, for 100 parts by weight of the total amount of the silane compounds.

As the basic catalyst, an inorganic base such as lithium hydroxide, sodium hydroxide, potassium hydroxide, calcium hydroxide, barium hydroxide, sodium hydrogencarbonate, potassium hydrogencarbonate, sodium carbonate, and potassium carbonate can be used.

In addition, as examples of the organic bases among the above basic catalyst, linear, branched, or cyclic monoalkylamines such as n-hexylamine, n-heptylamine, n-octylamine, n-nonylamine, n-decylamine, and cyclohexylamine; linear, branched, or cyclic dialkylamines such as di-n-butylamine, di-n-pentylamine, di-n-hexylamine, di-n-heptylamine, di-n-octylamine, di-n-nonylamine, di-n-decylamine, cyclohexylmethylamine, and dicyclohexylamine; linear, branched, or cyclic trialkylamines such as triethylamine, tri-n-propylamine, tri-n-butylamine, tri-n-pentylamine, tri-n-hexylamine, tri-n-heptylamine, tri-n-octylamine, tri-n-nonylamine, tri-n-decylamine, cyclohexyldimethylamine, dicyclohexylmethylamine, and tricyclohexylamine; aromatic amines such as aniline, N-methylaniline, N,N-dimethylaniline, 2-methylaniline, 3-methylaniline, 4-methylaniline, 4-nitroaniline, diphenylamine, triphenylamine, and naphthylamine; diamines such as ethylenediamine, N,N,N',N'-tetramethylethylenediamine, tetramethylenediamine, hexamethylenediamine, 4,4'-diaminodiphenylmethane, 4,4'-diaminodiphenyl ether, 4,4'-diaminobenzophenone, 4,4'-diaminodiphenylamine, 2,2-bis(4-aminophenyl)propane, 2-(3-aminophenyl)-2-(4-aminophenyl)propane, 2-(4-aminophenyl)-2-(3-hydroxyphenyl)propane, 2-(4-aminophenyl)-2-(4-hydroxyphenyl)propane, 1,4-bis[1-(4-aminophenyl)-1-methylethyl]benzene, and 1,3-bis[1-(4-aminophenyl)-1-methylethyl]benzene; imidazoles such as imidazole, benzimidazole, 4-methylimidazole, and 4-methyl-2-phenylimidazole; pyridines such as pyridine, 2-methylpyridine, 4-methylpyridine, 2-ethylpyridine, 4-ethylpyridine, 2-phenylpyridine, 4-phenylpyridine, 2-methyl-4-phenylpyridine, nicotine, nicotinic acid, nicotinamide, quinoline, 4-hydroxyquinoline, 8-oxyquinoline, and acridine; piperazines such as piperazine and 1-(2'-hydroxyethyl)piperazine; other nitrogen-containing heterocyclic compounds such as pyrazine, pyrazole, pyridazine, quinoxaline, purine, pyrrolidine, piperidine, morpholine, 4-methylmorpholine, 1,4-dimethylpiperazine, and 1,4-diazabicyclo[2.2.2]octane; and the like can be given.

Of these basic catalysts, triethylamine, tri-n-propylamine, tri-n-butylamine, pyridine, and the like are preferable.

These basic catalysts may be used either individually or in combination of two or more. The basic catalyst is usually used in an amount of 0.01-10,000 parts by weight for 100 parts by weight of all of the silane compounds.

As examples of the solvent used in the polycondensation, linear or branched ketones such as 2-butanone, 2-pentanone, 3-methyl-2-butanone, 2-hexanone, 4-methyl-2-pentanone, 3-methyl-2-pentanone, 3,3-dimethyl-2-butanone, 2-heptanone, and 2-octanone; cyclic ketones such as cyclopentanone, 3-methylcyclopentanone, cyclohexanone, 2-methylcyclohexanone, 2,6-dimethylcyclohexanone, and isophorone; propylene glycol monoalkyl ether acetates such as propylene glycol monomethyl ether acetate, propylene glycol monoethyl ether acetate, propylene glycol mono-n-propyl ether acetate, propylene glycol mono-i-propyl ether acetate, propylene glycol mono-n-butyl ether acetate, propylene glycol mono-i-butyl ether acetate, propylene glycol mono-sec-butyl ether acetate, and propylene glycol mono-t-butyl ether acetate; alkyl 2-hydroxypropionates such as methyl 2-hydroxypropionate, ethyl 2-hydroxypropionate, n-propyl 2-hydroxypropionate, i-propyl 2-hydroxypropionate, n-butyl 2-hydroxypropionate, i-butyl 2-hydroxypropionate, sec-butyl 2-hydroxypropionate, and t-butyl 2-hydroxypropionate; alkyl 3-alkoxypropionates such as methyl 3-methoxypropionate, ethyl 3-methoxypropionate, methyl 3-ethoxypropionate, and ethyl 3-ethoxypropionate; alcohols such as ethanol, n-propanol, i-propanol, n-butanol, t-butanol, cyclohexanol, ethylene glycol monomethyl ether, ethylene glycol monoethyl ether, ethylene glycol mono-n-propyl ether, ethylene glycol mono-n-butyl ether, propylene glycol monomethyl ether, propylene glycol monoethyl ether, and propylene glycol mono-n-propyl ether; dialkylene glycol dialkyl ethers such as diethylene glycol dimethyl ether, diethylene glycol diethyl ether, diethylene glycol di-n-propyl ether, and diethylene glycol di-n-butyl ether; ethylene glycol monoalkyl ether acetates such as ethylene glycol monomethyl ether acetate, ethylene glycol monoethyl ether acetate, and ethylene glycol mono-n-propyl ether acetate; aromatic hydrocarbons such as toluene and xylene; other esters such as ethyl 2-hydroxy-2-methylpropionate, ethyl ethoxyacetate, ethyl hydroxyacetate, methyl 2-hydroxy-3-methylbutyrate, 3-methoxybutyl acetate, 3-methyl-3-methoxybutyl acetate, 3-methyl-3-methoxybutyl propionate, 3-methyl-3-methoxybutyl butyrate, ethyl acetate, n-propyl acetate, n-butyl acetate, methyl acetoacetate, ethyl acetoacetate, methyl pyruvate, and ethyl pyruvate; N-methylpyrrolidone, N,N-dimethylformamide, N,N-dimethylacetamide, benzyl ethyl ether, di-n-hexyl ether, diethylene glycol monomethyl ether, diethylene glycol monoethyl ether, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, propylene carbonate; and the like can be given.

These solvents may be used either individually or in combination of two or more.

These solvents are usually used in the amount of 2,000 parts by weight or less for 100 parts by weight of all of the silane compounds.

The polycondensation reaction for producing the polysiloxane α can be preferably carried out either in the presence or absence of a solvent, such as 2-butanone, 2-pentanone, 3-methyl-2-butanone, 2-hexanone, 4-methyl-2-pentanone, 3-methyl-2-pentanone, 3,3-dimethyl-2-butanone, 2-heptanone, 2-octanone, cyclopentanone, 3-methylcyclopentanone, cyclohexanone, 2-methylcyclohexanone, 2,6-dimethylcyclohexanone, diethylene glycol dimethyl ether, diethylene glycol diethyl ether, diethylene glycol di-n-propyl ether, diethylene glycol di-n-butyl ether, ethylene glycol monomethyl ether acetate, ethylene glycol monoethyl ether acetate, and ethylene glycol mono-n-propyl ether acetate.

In addition, water may be added to the reaction mixture of the polycondensation reaction. The amount of water to be added is usually 10,000 parts by weight or less for 100 parts by weight of all of the silane compounds. Under the acidic or basic conditions, the polycondensation reaction is carried out at a temperature of usually -50 to 300°C, and preferably 20 to 100°C, usually for a period of one minute to 100 hours.

### <Radiation-sensitive resin composition>

The radiation-sensitive resin composition of the present invention comprises (a) the siloxane resin (α) and (b) a photoacid generator (hereinafter referred to as "acid generator (b)").

### <Acid generator (b)>

The acid generator (b) is a component generating an acid by being exposed to radiation and causing the acid-dissociable group in the siloxane resin (a) to dissociate by the action of the acid. As a result, the exposed areas of the resist film become readily soluble in an alkaline developer, whereby a positive-tone resist pattern is formed.

The type of the acid generator (b) is not specifically limited insofar as it can exhibit the above action. A preferable acid generator (b) contains a compound that generates trifluoromethansulfonic acid or an acid shown by the following formula (3) (hereinafter referred to as "acid (3)") upon exposure (hereinafter referred to as "acid generator (β1)"). 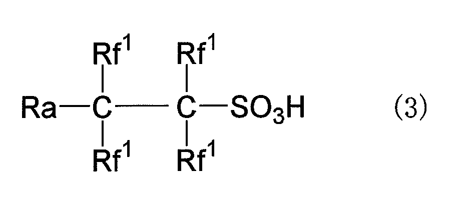 wherein Rf¹ individually represents a fluorine atom or trifluoromethyl group, Ra represents a hydrogen atom, fluorine atom, linear or branched alkyl group having 1 to 20 carbon atoms, linear or branched fluoroalkyl group having 1 to 20 carbon atoms, substituted or unsubstituted monovalent cyclic hydrocarbon group having 3 to 20 carbon atoms, or substituted or unsubstituted monovalent cyclic fluorohydrocarbon group having 3 to20 carbon atoms.

As examples of the acid generator (β1), onium salts, sulfone compounds, sulfonic acid compounds, carboxylic acid compounds, diazoketone compounds, and halogen-containing compounds can be given.

Although the acid generator (β1) can be used alone as the acid generator (b) in the present invention, the acid generator (β1) may be used in combination with a photoacid generator (hereinafter referred to as "acid generator (β2)") that generates an acid shown by the following formula (4) (hereinafter referred to as "acid (4)"), an acid shown by the following formula (5) (hereinafter referred to as "acid (5)"), or an acid shown by the following formula (6) (hereinafter referred to as "acid (6)").

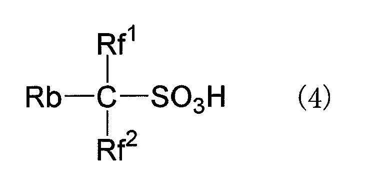

Rs-SO₃H (5)

Rc-COOH (6)

In the formula (4), Rf¹ represents a fluorine atom or trifluoromethyl group, Rf² represents a hydrogen atom, fluorine atom, methyl group, or trifluoromethyl group, Rb represents a hydrogen atom, a linear or branched alkyl group having 1 to 20 carbon atoms, a substituted or unsubstituted monovalent cyclic hydrocarbon group having 3 to 20 carbon atoms, or a substituted or unsubstituted monovalent cyclic fluorohydrocarbon group having 3 to 20 carbon atoms. In the formula (5), Rs represents a linear or branched alkyl group having 1 to 20 carbon atoms or a substituted or unsubstituted monovalent cyclic hydrocarbon group having 3 to 20 carbon atoms.

In the formula (6), Rc represents a linear or branched alkyl group having 1 to 20 carbon atoms, a linear or branched fluoroalkyl group having 1 to 20 carbon atoms, a substituted or unsubstituted monovalent cyclic hydrocarbon group having 3 to 20 carbon atoms, or a substituted or unsubstituted monovalent cyclic fluorohydrocarbon group having 3 to 20 carbon atoms.

As specific examples of the linear or branched alkyl group having 1 to 20 carbon atoms represented by Ra, Rb, Rs, or Rc in the formulas (3) to (6), a methyl group, ethyl group, n-propyl group, i-propyl group, n-butyl group, i-butyl group, sec-butyl group, t-butyl group, n-pentyl group, n-hexyl group, n-heptyl group, and n-octyl group can be given. As specific examples of the linear or branched fluoroalkyl group having 1 to 20 carbon atoms represented by Ra or Rc, a trifluoromethyl group, pentafluoroethyl group, heptafluoro-n-propyl group, heptafluoro-i-propyl group, nonafluoro-n-butyl group, nonafluoro-i-butyl group, nonafluoro-sec-butyl group, nonafluoro-t-butyl group, perfluoro-n-pentyl group, perfluoro-n-hexyl group, perfluoro-n-heptyl group, and perfluoro-n-octyl group can be given.

As examples of the monovalent cyclic hydrocarbon group having 3 to 20 carbon atoms, the monovalent cyclic fluorohydrocarbon group having 3 to 20 carbon atoms, or their substitution derivatives represented by Ra, Rb, Rs, or Rc, groups of the following formulas (7)-(13) can be given.

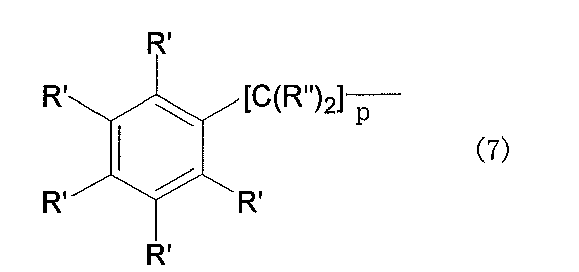

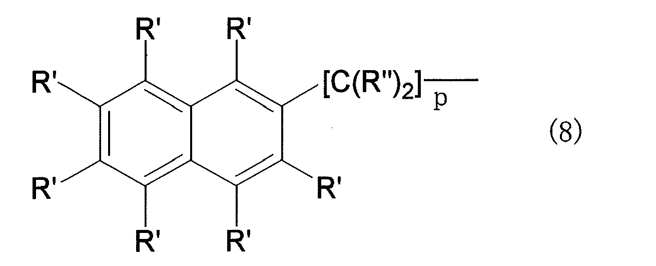

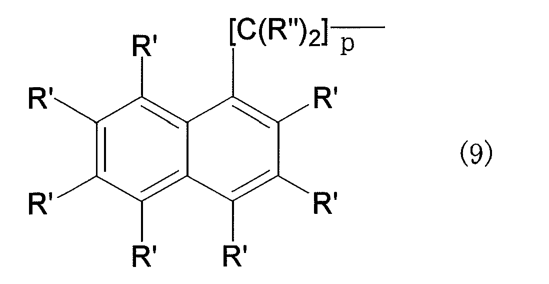

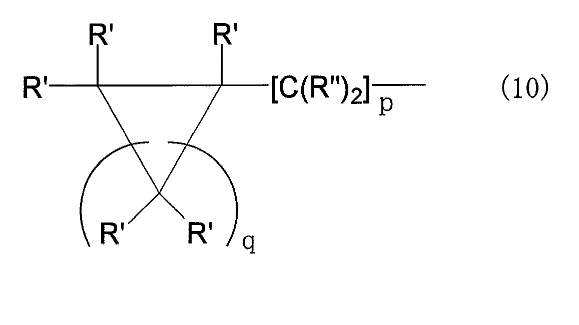

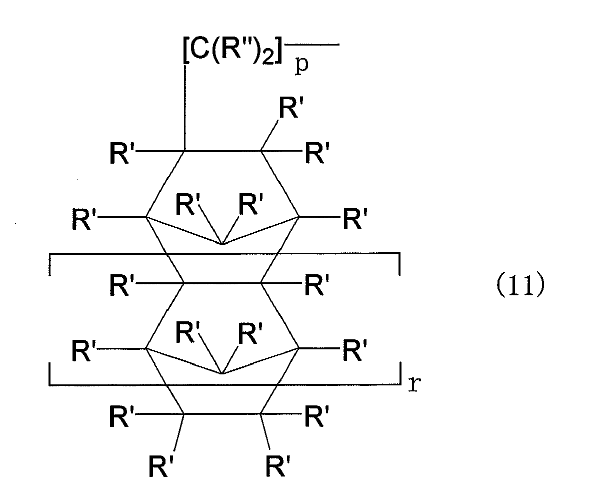

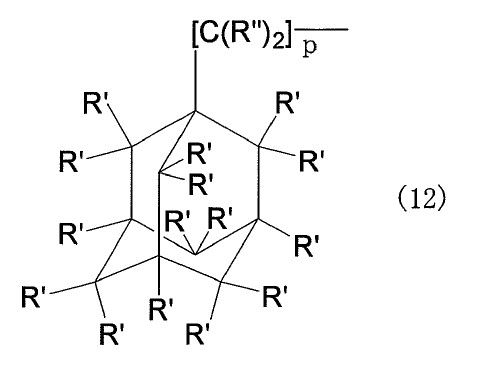

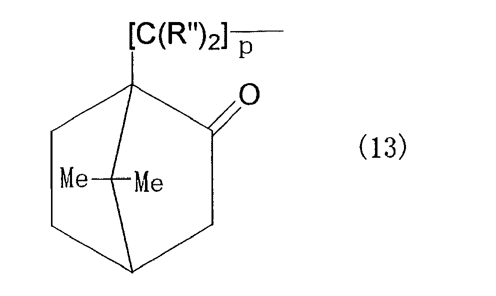

In the formulas (7) to (13), R' individually represents a hydrogen atom, halogen atom, hydroxyl group, acetyl group, carboxyl group, nitro group, cyano group, primary amino group, secondary amino group, linear or branched alkoxyl group having 1 to 10 carbon atoms, linear or branched alkyl group having 1 to 10 carbon atoms, or linear or branched fluoroalkyl group having 1 to 10 carbon atoms, R" individually represents a hydrogen atom, halogen atom, linear or branched alkyl group having 1 to 10 carbon atoms, or a linear or branched fluoroalkyl group having 1 to 10 carbon atoms, p is an integer of 0 to 10, and Me is a methyl group.

In the formula (10), q is an integer of 1 to 18. In the formula (11), r is an integer of 0 to 3.

Preferable examples of the acid (3) include:
trifluoromethanesulfonic acid, pentafluoroethanesulfonic acid,
heptafluoro-n-propanesulfonic acid, nonafluoro-n-butanesulfonic acid,
perfluoro-n-octanesulfonic acid, 1,1,2,2-tetrafluoro-n-propanesulfonic acid,
1,1,2,2-tetrafluoro-n-butanesulfonic acid, 1,1,2,2-tetrafluoro-n-octanesulfonic acid, acids of the following formulas (3-1) or (3-2), and the like.

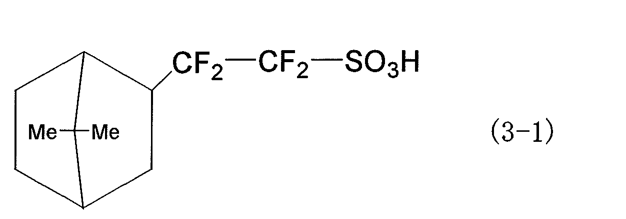

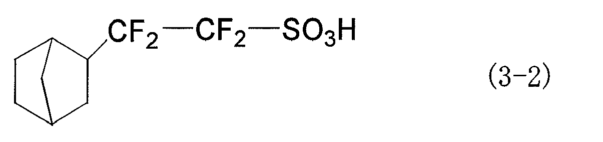

As preferable examples of the acid (4) in the present invention, 1,1-difluoroethanesulfonic acid, 1,1-difluoro-n-propanesulfonic acid, 1,1-difluoro-n-butanesulfonic acid, 1,1-difluoro-n-octanesulfonic acid, acids of the following formulas (4-1) to (4-4), and the like can be given.

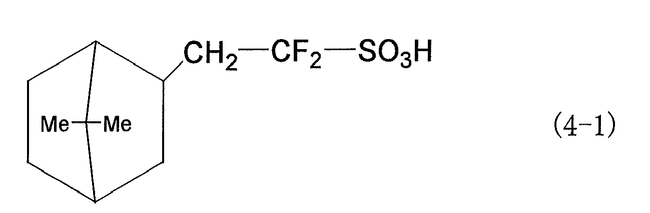

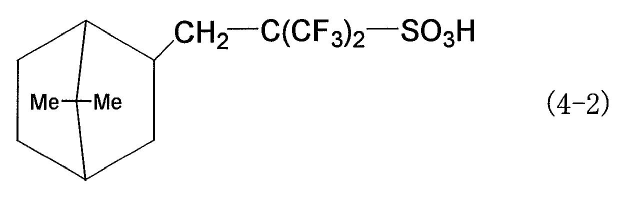

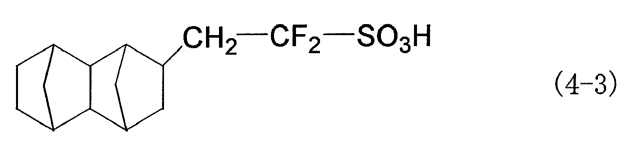

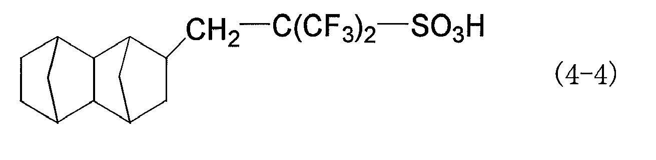

As preferable examples of the acid (5) in the present invention, linear, branched, or cyclic alkylsulfonic acids such as methanesulfonic acid, ethanesulfonic acid, n-propanesulfonic acid, n-butanesulfonic acid, i-butanesulfonic acid, sec-butanesulfonic acid, t-butanesulfonic acid, n-pentanesulfonic acid, n-hexanesulfonic acid, n-octanesulfonic acid, cyclopentanesulfonic acid, and cyclohexanesulfonic acid; aromatic sulfonic acids such as benzenesulfonic acid, p-toluenesulfonic acid, benzylsulfonic acid, α-naphthalenesulfonic acid, and β-naphthalenesulfonic acid; 10-camphorsulfonic acid; acids produced by coupling a group -SO₃H to the coupling site of the group of any of the above formulas (7) to (13); and the like can be given.

The following acids can be given as preferable examples of the acids (6) in the present invention: acetic acid, n-propionic acid, butyric acid, isobutyric acid, valeric acid, isovaleric acid, caproic acid, benzoic acid, salicylic acid, phthalic acid, terephthalic acid, α-naphthalenecarboxylic acid, β-naphthalenecarboxylic acid, cyclobutanecarboxylic acid, cyclopentanecarboxylic acid, cyclohexanecarboxylic acid, 1,1-cyclobutanedicarboxylic acid, 1,2-cyclobutanedicarboxylic acid, 1,1-cyclopentanedicarboxylic acid, 1,2-cyclopentanedicarboxylic acid, 1,3-cyclopentanedicarboxylic acid, 1,1-cyclohexanedicarboxylic acid, 1,2-cyclohexanedicarboxylic acid, 1,3-cyclohexanedicarboxylic acid, 1,4-cyclohexanedicarboxylic acid, 2-norbornanecarboxylic acid, 2,3-norbornanedicarboxylic acid, norbornyl-2-acetic acid, 1-adamantanecarboxylic acid, 1-adamantaneacetic acid, 1,3-adamantanedicarboxylic acid, 1,3-adamantanediacetic acid, lithocholic acid, deoxycholic acid, chenodeoxycholic acid, and cholic acid, as well as acids produced by bonding a group -COOH to the bonding site of the group of any of the formulas (7) to (13).

As examples of the onium salt compound generating the acid (3), acid (4), acid (5), or acid (6), a diphenyliodonium salt, bis(4-t-butylphenyl)iodonium salt, triphenylsulfonium salt, 4-hydroxyphenyl-phenyl-methylsulfonium salt, cyclohexyl-2-oxocyclohexyl-methylsulfonium salt, dicyclohexyl-2-oxocyclohexylsulfonium salt, 2-oxocyclohexyldimethylsulfonium salt, 4-hydroxyphenyl-benzyl-methylsulfonium salt, 1-naphthyldimethylsulfonium salt, 1-naphthyldiethylsulfonium salt, 4-cyano-1-naphthyldimethylsulfonium salt, 4-cyano-1-naphthyldiethylsulfonium salt, 4-nitro-1-naphthyldimethylsulfonium salt, 4-nitro-1-naphthyldiethylsulfonium salt, 4-methyl-1-naphthyldimethylsulfonium salt, 4-methyl-1-naphthyldiethylsulfonium salt, 4-hydroxy-1-naphthyldimethylsulfonium salt, 4-hydroxy-1-naphthyldiethylsulfonium salt, 1-(4-hydroxynaphthalen-1-yl)tetrahydrothiophenium salt, 1-(4-methoxynaphthalen-1-yl)tetrahydrothiophenium salt, 1-(4-ethoxynaphthalen-1-yl)tetrahydrothiophenium salt, 1-(4-n-butoxynaphthalen-1-yl)tetrahydrothiophenium salt, 1-(4-methoxymethoxynaphthalen-1-yl)tetrahydrothiophenium salt, 1-(4-ethoxymethoxynaphthalen-1-yl)tetrahydrothiophenium salt, 1-[4-(1-methoxyethoxy)naphthalen-1-yl]tetrahydrothiophenium salt, 1-[4-(2-methoxyethoxy)naphthalen-1-yl]tetrahydrothiophenium salt, 1-(4-methoxycarbonyloxynaphthalen-1-yl)tetrahydrothiophenium salt, 1-(4-ethoxycarbonyloxynaphthalen-1-yl)tetrahydrothiophenium salt, 1-(4-n-propoxycarbonyloxynaphthalen-1-yl)tetrahydrothiophenium salt, 1-(4-i-propoxycarbonyloxynaphthalen-1-yl)tetrahydrothiophenium salt, 1-(4-n-butoxycarbonyloxynaphthalen-1-yl)tetrahydrothiophenium salt, 1-(4-t-butoxycarbonyloxynaphthalen-1-yl)tetrahydrothiophenium salt, 1-[4-(2-tetrahydrofuranyloxy)naphthalen-1-yl]tetrahydrothiophenium salt, 1-[4-(2-tetrahydropyranyloxy)naphthalen-1-yl]tetrahydrothiophenium salt, 1-(4-benzyloxynaphthalen-1-yl)tetrahydrothiophenium salt, and 1-[1-(1-naphthylacetomethyl)]tetrahydrothiophenium salt; and the like can be given.

As examples of sulfone compounds generating the acid (3), acid (4), or acid (5), β-ketosulfone, β-sulfonylsulfone, and α-diazo compounds of these compounds can be given.

As examples of the sulfonic acid compound generating the acid (3), acid (4), or acid (5), sulfonic acid esters, sulfonic acid imides, arylsulfonic acid esters, and iminosulfonates can be given.

As examples of carboxylic acid compounds generating the acid (6), carboxylic acid ester, carboxylic acid imide, and carboxylic acid cyanate can be given.

As examples of the diazoketone compound generating the acid (3), acid (4), acid (5), or acid (6), 1,3-diketo-2-diazo compounds, diazobenzoquinone compounds, and diazonaphthoquinone compounds can be given.

As examples of halogen-containing compounds generating the acid (3), acid (4), acid (5), or acid (6), haloalkyl group-containing hydrocarbon compounds and haloalkyl group-containing heterocyclic compounds can be given.

The blend ratio of the acid generator (β1) and the acid generator (β2) in the present invention is preferably from 100:0 to 100:150 (by weight).

In addition, as examples of the preferable acid generator other than the acid generator (β1) and the acid generator (β2) (hereinafter referred to as "the other acid generator"),
other onium salt compounds such as diphenyliodonium pyrenesulfonate, diphenyliodonium n-dodecylbenzenesulfonate, diphenyliodonium hexafluoroantimonate, bis(4-t-butylphenyl)iodonium n-dodecylbenzenesulfonate, bis(4-t-butylphenyl)iodonium hexafluoroantimonate, bis(4-t-butylphenyl)iodonium naphthalenesulfonate, triphenylsulfonium hexafluoroantimonate, triphenylsulfonium naphthalenesulfonate, triphenylsulfonium 10-camphorsulfonate, 4-hydroxyphenyl·phenyl·methylsulfonium p-toluenesulfonate, and 4-hydroxyphenyl·benzyl·methylsulfonium p-toluenesulfonate; other sulfone compounds such as 4-trisphenacylsulfone, mesitylphenacylsulfone, and bis(phenylsulfonyl)methane; other sulfonic acid compounds such as benzoin tosylate and nitrobenzyl 9,10-diethoxyanthracene-2-sulfonate; other diazoketone compounds such as 1,2-naphthoquinonediazido-4-sulfonyl chloride, 1,2-naphthoquinonediazido-5-sulfonyl chloride, 1,2-naphthoquinonediazido-4-sulfonate or 1,2-naphthoquinonediazido-5-sulfonate of 2,3,4,4'-tetrahydroxybenzophenone, and 1,2-naphthoquinonediazido-4-sulfonate or 1,2-naphthoquinonediazido-5-sulfonate of 1,1, 1-tris(4-hydroxyphenyl)ethane; and other halogen-containing compounds such as (trichloromethyl)-s-triazine derivatives such as phenylbis(trichloromethyl)-s-triazine, 4-methoxyphenylbis(trichloromethyl)-s-triazine, and 1-naphthylbis(trichloromethyl)-s-triazine, and 1,1-bis(4-chlorophenyl)-2,2,2-trichloroethane; a disulfonyldiazomethane compound of the following formula (14), 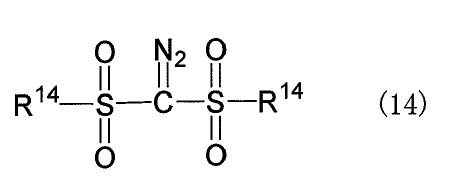 wherein R¹⁴ individually represents a monovalent group such as an alkyl group, aryl group, halogenated alkyl group, and halogenated aryl group; oxime sulfonate compounds of the following formulas (15-1) or (15-2), 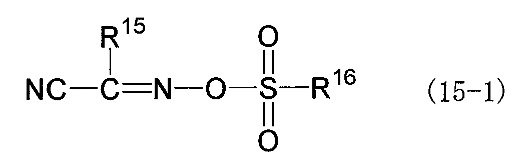 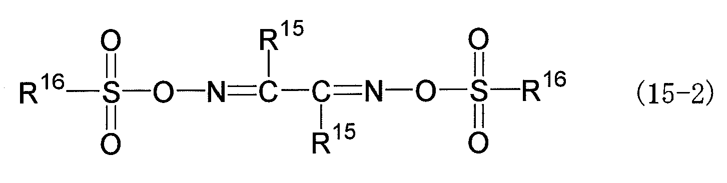 wherein R¹⁵ and R¹⁶ individually represent a monovalent organic group; and the like can be given.

As specific examples of the disulfonyldiazomethane compound, bis(trifluoromethanesulfonyl)diazomethane, bis(cyclohexanesulfonyl)diazomethane, bis(benzenesulfonyl)diazomethane, bis(p-toluenesulfonyl)diazomethane, methanesulfonyl-p-toluenesulfonyldiazomethane, cyclohexanesulfonyl-1,1-dimethylethylsulfonyldiazomethane, bis(1,1-dimethyletanesulfonyl)diazomethane, bis(3,3-dimethyl-1,5-dioxaspiro[5.5]dodecane-8-sulfonyl)diazomethane, and bis(1,4-dioxaspiro[4.5]decane-7-sulfonyl)diazomethane can be given.

As specific examples of R¹⁵ in the formulas (15-1) and (15-2), a methyl group, ethyl group, n-propyl group, phenyl group, tosyl group, trifluoromethyl group, and nonafluoro-n-butyl group can be given.

As specific examples of R¹⁶ , a phenyl group, tosyl group, and naphthyl group can be given.

As other preferable examples of the other acid generators, sulfonates, such as trifluoromethanesulfonate, nonafluoro-n-butanesulfonate, perfluoro-n-octanesulfonate, benzenesulfonate, p-toluenesulfonate, methanesulfonate, and n-butanesulfonate of the following oxime compounds can be given.

As examples of the oxime compound which can be used, the following can be given: 2,2-difluoro-2-methylacetophenone-O-methylsulfonyloxime, 2,2-dichloro-2-methoxymethyl-2'-methylacetophenone-O-(n-propyl)sulfonyloxime, 2,2-difluoro-2-ethylacetophenone-O-(n-propyl)sulfonyloxime, 2,2-difluoro-2-phenylacetophenone-O-ethylsulfonyloxime, 2-chloro-2-fluoro-2-cyclohexylacetophenone-O-(p-tolyl)sulfonyloxime, 2,2-difluoro-2-(n-propyl)acetophenone-O-(10-camphor)sulfonyloxime, 2,2-difluoro-2-methyl-4'-methoxyacetophenone-O-(n-propyl)sulfonyloxime, 2,2-difluoro-2-methylacetonaphthone-O-trifluoromethylsulfonyloxime, 1,1-difluoro-1-phenylacetone-O-(n-butyl)sulfonyloxime, (1,1-difluoro-1-cyclohexyl)methyl-2'-thienylketone-O-methylsulfonyloxime, (1,1-dichloro-1-phenyl)methyl-2'-furylketone-O-(n-propyl)sulfonyloxime, 2,2-difluoro-2-methylcarbonylacetophenone-O-methylsulfonyloxime, 2,2-dichloro-2-methoxymethylcarbonyl-2'-methylacetophenone-O-(n-propyl)sulfonyloxime, 2,2-difluoro-2-ethylcarbonylacetophenone-O-(n-propyl)sulfonyloxime, 2,2-difluoro-2-phenylcarbonylacetophenone-O-ethylsulfonyloxime, 2-chloro-2-fluoro-2-cyclohexylcarbonylacetophenone-O-(p-tolyl)sulfonyloxime, 2,2-difluoro-2-(n-propylcarbonyl)acetophenone-O-(10-camphor)sulfonyloxime, 2,2-difluoro-2-methylcarbonyl-4'-methoxyacetophenone-O-(n-propyl)sulfonyloxime, 2,2-difluoro-2-methylcarbonylacetonaphthone-O-trifluoromethylsulfonyloxime, 1,1-difluoro-1-phenylcarbonylacetone-O-(n-butyl)sulfonyloxime, (1,1-difluoro-1-cyclohexylcarbonyl)methyl-2'-thienylketone-O-methylsulfonyloxime, (1,1-dichloro-1-phenylcarbonyl)methyl-2'-furylketone-O-(n-propyl)sulfonyloxime, 2,2-difluoro-2-methoxycarbonylacetophenone-O-methylsulfonyloxime, 2,2-difluoro-2-ethoxycarbonylacetophenone-O-(n-propyl)sulfonyloxime, 2,2-difluoro-2-phenoxycarbonylacetophenone-O-ethylsulfonyloxime, 2-chloro-2-fluoro-2-cyclohexyloxycarbonylacetophenone-O-(p-tolyl)sulfonyloxime, 2,2-difluoro-2-(n-propoxycarbonyl)acetophenone-O-(10-camphor)sulfonyloxime, 2,2-difluoro-2-methoxycarbonyl-4'-methoxyacetophenone-O-(n-propyl)sulfonyloxime, 2,2-difluoro-2-methoxycarbonylacetonaphthone-O-trifluoromethylsulfonyloxime, 1,1-difluoro-1-phenoxycarbonylacetone-O-(n-butyl)sulfonyloxime, (1,1-dichloro-1-cyclohexyloxycarbonyl)methyl-2'-thienylketone-O-methylsulfonyloxime, (1,1-difluoro-1-phenoxycarbonyl)methyl-2'-furylketone-O-(n-propyl)sulfonyloxime, 2,2-difluoro-2-(N,N-dimethylamino)acetophenone-O-methylsulfonyloxime, 2,2-difluoro-2-(N-ethylamide)-2'-methylacetophenone-O-(n-propyl)sulfonyloxime, 2,2-difluoro-2-(N-phenylamide)acetophenone-O-ethylsulfonyloxime, 2-chloro-2-fluoro-2-(N-methyl-N-cyclohexylamide)acetophenone-O-(p-tolyl)sulfonyloxime, 2,2-difluoro-2-(n-propylamide)acetophenone-O-(10-camphor)sulfonyloxime, 2,2-difluoro-2-(N-methyl-N-cyclohexylamide)-4'-methoxyacetophenone-O-(n-propyl)sulfonyloxime, 2,2-difluoro-2-(N,N-dimethylamide)acetonaphthone-O-trifluoromethylsulfonyloxime, 1,1-difluoro-1-(N-phenylamide)acetone-O-(n-butyl)sulfonyloxime, [1,1-difluoro-1-(N-cydohexylamide)]methyl-2'-thienylketone-O-methylsulfonyloxime, (1,1-dichloro-1-(N-phenylamide))methyl-2'-furylketone-O-(n-propyl)sulfonyloxime, 2,2-difluoro-2-thiomethoxyacetophenone-O-methylsulfonyloxime, 2,2-difluoro-2-thioethoxyacetophenone-O-(n-propyl)sulfonyloxime, 2,2-difluoro-2-thiophenoxyacetophenone-O-ethylsulfonyloxime, 2-chloro-2-fluoro-2-thiocyclohexyloxyacetophenone-O-(p-tolyl)sulfonyloxime, 2,2-difluoro-2-thiomethoxy-4'-methoxyacetophenone-O-(n-propyl)sulfonyloxime, 2,2-difluoro-2-thiomethoxyacetonaphthone-O-trifluoromethylsulfonyloxime, 1,1-difluoro-1 -thiophenoxyacetonc-O-(n-butyl)sulfonyloxime, (1,1-difluoro-1-thiocydohexyloxy)methyl-2'-thienylketone-O-methylsulfonyloxime, (1,1-dichloro-1-thiophenoxy)methyl-2'-furylketone-O-(n-propyl)sulfonyloxime, 2,2-difluoro-2-methylsulfinylacetophenone-O-methylsulfonyloxime, 2,2-difluoro-2-ethylsulfinylacetophenone-O-(n-propyl)sulfonyloxime, 2,2-difluoro-2-phenylsulfinylacetophenone-O-ethylsulfonyloxime, 2-chloro-2-fluoro-2-cyclohexylsulfinylacetophenone-O-(p-tolyl)sulfonyloxime, 2,2-difluoro-2-(n-propylsulfinyl)acetophenone-O-(10-camphor)sulfonyloxime, 2,2-difluoro-2-methylsulfinyl-4'-methoxyacetophenone-O-(n-propyl)sulfonyloxime, 2,2-difluoro-2-methylsulfinylacetonaphthone-O-trifluoromethylsulfonyloxime, 1,1-difluoro-1-phenylsulfinylacetone-O-(n-butyl)sulfonyloxime, (1,1-difluoro-1-cyclohexylsulfinyl)methyl-2'-thienylketone-O-methylsulfonyloxime, (1,1-dichloro-1-phenylsulfinyl)methyl-2'-furylketone-O-(n-propyl)sulfonyloxime, 2,2-difluoro-2-phenylsulfonylacetophenone-O-(n-propyl)sulfonyloxime, 2,2-difluoro-2-phenylsulfonylacetophenone-O-methylsulfonyloxime, 2,2-difluoro-2-phenylsulfonylacetophenone-O-ethylsulfonyloxime, 2,2-dichloro-2-phenylsulfonylacetophenone-O-methylsulfonyloxime, 2,2-difluoro-2-phenylsulfonylacetophenone-O-(10-camphor)sulfonyloxime, 2,2-difluoro-2-phenylsulfonylacetophenone-O-(p-tolyl)sulfonyloxime, 2,2-difluoro-2-phenylsulfonylacetophenone-O-trifluoromethylsulfonyloxime, 2,2-difluoro-2-phenylsulfonyl-4'-methoxyacetophenone-O-(n-propyl)sulfonyloxime, 2,2-difluoro-2-phenylsulfonyl-4'-methoxyacetophenone-O-methylsulfonyloxime, 2,2-difluoro-2-phenylsulfonyl-4'-methoxyacetophenone-O-ethylsulfonyloxime, 2,2-dichloro-2-phenylsulfonyl-4'-methoxyacetophenone-O-methylsulfonyloxime, 2,2-difluoro-2-phenylsulfonyl-4'-methoxyacetophenone-O-(10-camphor)sulfonyloxime, 2,2-difluoro-2-phenylsulfonyl-4'-methoxyacetophenone-O-(p-tolyl)sulfonyloxime, 2,2-difluoro-2-phenylsulfonyl-4'-methoxyacetophenone-O-trifluoromethylsulfonyloxime, 2,2-difluoro-2-phenylsulfonyl-2'-methylacetophenone-O-(n-propyl)sulfonyloxime, 2,2-difluoro-2-phenylsulfonyl-2'-methylacetophenone-O-methylsulfonyloxime, 2,2-difluoro-2-phenylsulfonyl-2'-methylacetophenone-O-ethylsulfonyloxime, 2,2-dichloro-2-phenylsulfonyl-2'-methylacetophenone-O-methylsulfonyloxime, 2,2-difluoro-2-phenylsulfonyl-2'-methylacetophenone-O-camphorsulfonyloxime, 2,2-difluoro-2-cyclohexylsulfonylacetophenone-O-(n-propyl)sulfonyloxime, 2,2-difluoro-2-cyclohexylsulfonylacetophenone-O-methylsulfonyloxime, 2,2-difluoro-2-cyclohexylsulfonylacetophenone-O-ethylsulfonyloxime, 2,2-dichloro-2-cyclohexylsulfonylacetophenone-O-methylsulfonyloxime, 2,2-difluoro-2-cyclohexylsulfonylacetophenone-O-(10-camphor)sulfonyloxime, 2,2-difluoro-2-cyclohexylsulfonylacetophenone-O-trifluoromethylsulfonyloxime, 2,2-difluoro-2-methylsulfonyl-4'-methoxyacetophenone-O-(n-propyl)sulfonyloxime, 2,2-difluoro-2-methylsulfonyl-4'-methoxyacetophenone-O-methylsulfonyloxime, 2,2-difluoro-2-methylsulfonyl-4'-methoxyacetophenone-O-ethylsulfonyloxime, 2,2-dichloro-2-methylsulfonyl-4'-methoxyacetophenone-O-methylsulfonyloxime, 2,2-difluoro-2-methylsulfonyl-4'-methoxyacetophenone-O-(10-camphor)sulfonyloxime, 2,2-difluoro-2-methylsulfonyl-4'-methoxyacetophenone-O-trifluoromethylsulfonyloxime, 2,2-dibromo-2-phenylsulfonylacetophenone-O-(10-camphor)sulfonyloxime, 2-chloro-2-fluoro-2-phenylsulfonylacetophenone-O-ethylsulfonyloxime, 2-chloro-2-fluoro-2-phenylsulfonylacetophenone-O-benzylsulfonyloxime, 2,2-difluoro-2-phenylsulfonylacetophenone-O-(1-naphthyl)sulfonyloxime, 2,2-dichloro-2-methylsulfonylacetophenone-O-(p-bromophenyl)sulfonyloxime, 2,2-difluoro-2-phenylsulfonylacetophenone-O-(2-thienyl)sulfonyloxime, 2,2-difluoro-2-cyclohexylsulfonyl-2'-cyanoacetophenone-O-ethylsulfonyloxime, 2,2-difluoro-2-ethylsulfonylacetophenone-O-(n-propyl)sulfonyloxime, 2,2-difluoro-2-(n-propylsulfonyl)acetophenone-O-(10-camphor)sulfonyloxime, 2,2-difluoro-2-methylsulfonylacetonaphthone-O-trifluoromethylsulfonyloxime, 1,1-difluoro-1-phenylacetone-O-(n-butyl)sulfonyloxime, (1,1-difluoro-1-cyclohexyl)methylsulfonyl-2'-thienylketone-O-methylsulfonyloxime, (1,1-dichloro-1-phenyl)methylsulfonyl-2'-furylketone-O-(n-propyl)sulfonyloxime, 2,2-difluoro-2-cyanoacetophenone-O-methylsulfonyloxime, 2,2-dichloro-2-cyano-2'-methylacetophenone-O-(n-propyl)sulfonyloxime, 2,2-difluoro-2-cyanoacetophenone-O-ethylsulfonyloxime, 2-chloro-2-fluoro-2-cyanoacetophenone-O-(p-tolyl)sulfonyloxime, 2,2-difluoro-2-cyanoacetophenone-O-(10-camphor)sulfonyloxime, 2,2-difluoro-2-cyano-4'-methoxyacetophenone-O-(n-propyl)sulfonyloxime, 2,2-difluoro-2-cyanoacetonaphthone-O-trifluoromethylsulfonyloxime, 1,1-difluoro-1-cyanoacetone-O-(n-butyl)sulfonyloxime, (1,1-difluoro-1-cyano)methyl-2'-thienylketone-O-methylsulfonyloxime, (1,1-dichloro-1-cyano)methyl-2'-furylketone-O-(n-propyl)sulfonyloxime, 2,2-difluoro-2-nitroacetophenone-O-methylsulfonyloxime, 2,2-dichloro-2-nitro-2'-methylacetophenone-O-(n-propyl)sulfonyloxime, 2,2-difluoro-2-nitroacetophenone-O-ethylsulfonyloxime, 2-chloro-2-fluoro-2-nitroacetophenone-O-(p-tolyl)sulfonyloxime, 2,2-difluoro-2-nitroacetophenone-O-(10-camphor)sulfonyloxime, 2,2-difluoro-2-nitro-4'-methoxyacetophenone-O-(n-propyl)sulfonyloxime, 2,2-difluoro-2-nitroacetonaphthone-O-trifluoromethylsulfonyloxime, 1,1-difluoro-1-nitroacetone-O-(n-butyl)sulfonyloxime, (1,1-difluoro-1-nitro)methyl-2'-thienylketone-O-methylsulfonyloxime, (1,1-dichloro-1-nitro)methyl-2'-furylketone-O-(n-propyl)sulfonyloxime, 2,2-dioxo-5-phenylsulfonyldifluoromethyl-3H,4H-1,2,5-oxathioazine, 2,2-dioxo-4,4-difluoro-5-phenyl-3H-1,2,5-oxathioazine, 1,1-dioxo-2,2-difluoro-3-(n-propylsulfonyloxyimino)thiain, 2,2-difluoro-1,3-di(phenylsulfonyl)-1,3-propandial-O-(n-propylsulfonyl)dioxime, 1,1,5,5-tetrafluoro-1,5-di(methylsulfonyl)-2,4-pentandione-O,O-di(methylsulfonyl)dioxime, bis(2',2'-difluoro-2'-cyanoacetophenonoxime)-O-1,4-benzenesulfonic acid, 1,4-bis[1'-(n-propylsulfonyloxyimino)-2',2'-difluoro-2'-(methylsulfonyl)ethyl]benzene, 1,1,4,4-tetrafluoro-1,4-di(methylsulfonyl)-2,3 -butandione-O,O-di(methylsulfonyl)dioxime, and the like.

In the present invention, although the other acid generator can be used alone as the acid generator (b), combined use of the other acid generator with the acid generator (β1) or further with the acid generator (β2) is also preferable.

The acid generator (b) may be used either individually or in combination of two or more.

The amount of the acid generator (b) is usually 0.1-30 parts by weight, and preferably 0.5-20 parts by weight for 100 parts by weight of the total resin components from the viewpoint of ensuring sensitivity and developability as a resist. If the amount of the acid generator (b) is less than 0.1 part by weight, sensitivity and developability tend to decrease. If the amount exceeds 30 parts by weight, a rectangular resist pattern may not be obtained due to decreased radiation transmittance.

### <Additives>

Additives such as an acid diffusion controller, dissolution controller, and surfactant may be added to the radiation-sensitive resin composition of the present invention.

The acid diffusion controllers control diffusion of an acid generated from the acid generator upon exposure in the resist film to suppress undesired chemical reactions in the unexposed area.

The addition of such an acid diffusion controller improves storage stability of the resulting radiation-sensitive resin composition and resolution as a resist. Moreover, the addition of the acid diffusion controller prevents the line width of the resist pattern from changing due to changes in the post-exposure delay (PED) between exposure and development, whereby a composition with remarkably superior process stability can be obtained.

As the acid diffusion controller, an organic compound containing nitrogen of which the basicity does not change during exposure or heating for forming a resist pattern is preferable.

As examples of such nitrogen-containing organic compounds, compounds shown by the following formula (16) (hereinafter called "acid diffusion controller (γ)") can be given. 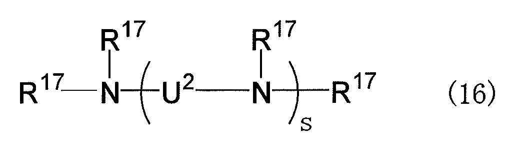 wherein R¹⁷ individually represents a hydrogen atom, a linear, branched, or cyclic alkyl group, aryl group, or aralkyl group which are either substituted or unsubstituted with a functional group such as a hydroxyl group, U² is a divalent organic group, and s is an integer of 0 to 2.

In the acid diffusion controller (γ), the compound having s = 0 is defined as "nitrogen-containing compound (γ1)" and the compound having s = 1 or 2 is defined as "nitrogen-containing compound (γ2)." Polyamino compounds and polymers having three or more nitrogen atoms are collectively referred to as "nitrogen-containing compound (γ3)."

As examples of the nitrogen-containing organic compound other than the acid diffusion controller (γ), quaternary ammonium hydroxide compounds, amide group-containing compounds, urea compounds, and nitrogen-containing heterocyclic compounds can be given.

Examples of the nitrogen-containing compound (γ1) include mono(cyclo)alkylamines such as n-hexylamine, n-heptylamine, n-octylamine, n-nonylamine, n-decylamine, and cyclohexylamine; di(cyclo)alkylamines such as di-n-butylamine, di-n-pentylamine, di-n-hexylamine, di-n-heptylamine, di-n-octylamine, di-n-nonylamine, di-n-decylamine, cyclohexylmethylamine, and dicyclohexylamine; tri(cyclo)alkylamines such as triethylamine, tri-n-propylamine, tri-n-butylamine, tri-n-pentylamine, tri-n-hexylamine, tri-n-heptylamine, tri-n-octylamine, tri-n-nonylamine, tri-n-decylamine, cyclohexyldimethylamine, dicyclohexylmethylamine, and tricyclohexylamine; alkanolamines such as ethanolamine, diethanolamine, and triethanolamine; and aromatic amines such as aniline, N-methylaniline, N,N-dimethylaniline, 2-methylaniline, 3-methylaniline, 4-methylaniline, 4-nitroaniline, 2,6-dimethylaniline, 2,6-diisopropylaniline, diphenylamine, triphenylamine, and naphthylamine.

Examples of the nitrogen-containing compound (γ2) include ethylenediamine, N,N,N',N'-tetramethylethylenediamine, N,N,N',N'-tetrakis(2-hydroxypropyl)ethylenediamine, tetramethylenediamine, 1,3 -bis[1-(4-aminophenyl)-1-methylethyl]benzenetetramethylenediamine, hexamethylenediamine, 4,4'-diaminodiphenylmethane, 4,4'-diaminodiphenyl ether, 4,4'-diaminobenzophenone, 4,4'-diaminodiphenylamine, 2,2-bis(4-aminophenyl)propane, 2-(3-aminophenyl)-2-(4-aminophenyl)propane, 2-(4-aminophenyl)-2-(3-hydroxyphenyl)propane, 2-(4-aminophenyl)-2-(4-hydroxyphenyl)propane, 1,4-bis[1-(4-aminophenyl)-1-methylethyl]benzene, 1,3-bis[1-(4-aminophenyl)-1-methylethyl]benzene, bis(2-dimethylaminoethyl) ether, and bis(2-diethylaminoethyl) ether.

Examples of the nitrogen-containing compound (γ3) include polyethyleneimine, polyallylamine, and a polymer of 2-dimethylaminoethylacrylamide.

As examples of the quaternary ammonium hydroxide compound, tetramethylammonium hydroxide, tetraethylammonium hydroxide, tetra-n-propylammonium hydroxide, and tetra-n-butylammonium hydroxide can be given.

As examples of the amide group-containing compounds, N-t-butoxycarbonyl group-containing amino compounds such as N-t-butoxycarbonyl-di-n-octylamine, N-t-butoxycarbonyl-di-n-nonylamine, N-t-butoxycarbonyl-di-n-decylamine, N-t-butoxycarbonyl-dicyclohexylamine, N-t-butoxycarbonyl-1-adamantylamine, N-t-butoxycarbonyl-N-methyl-1-adamantylamine, N,N-di-t-butoxycarbonyl-1-adamantylamine, N,N-di-t-butoxycarbonyl-N-methyl-1-adamantylamine, N-t-butoxycarbonyl-4,4'-diaminodiphenylmethane, N,N'-di-t-butoxycarbonylhexamethylenediamine, N,N,N'N'-tetra-t-butoxycarbonylhexamethylenediamine, N,N'-di-t-butoxycarbonyl-1,7-diaminoheptane, N,N'-di-t-butoxycarbonyl-1,8-diaminooctane, N,N'-di-t-butoxycarbonyl-1,9-diaminononane, N,N'-di-t-butoxycarbonyl-1,10-diaminodecane, N,N'-di-t-butoxycarbonyl-1,12-diaminododecane, N,N'-di-t-butoxycarbonyl-4,4'-diaminodiphenylmethane, N-t-butoxycarbonylbenzimidazole, N-t-butoxycarbonyl-2-methylbenzimidazole, and N-t-butoxycarbonyl-2-phenylbenzimidazole, formamide, N-methylformamide, N,N-dimethylformamide, acetamide, N-methylacetamide, N,N-dimethylacetamide, propioneamide, benzamide, pyrrolidone, N-methylpyrrolidone, and the like can be given.

As examples of the urea compound, urea, methylurea, 1,1-dimethylurea, 1,3-dimethylurea, 1,1,3,3-tetramethylurea, 1,3-diphenylurea, and tri-n-butylthiourea can be given.

Examples of the nitrogen-containing heterocyclic compounds include: imidazoles such as imidazole, 4-methylimidazole, 1-benzyl-2-methylimidazole, 4-methyl-2-phenylimidazole, benzimidazole, and 2-phenylbenzimidazole; pyridines such as pyridine, 2-methylpyridine, 4-methylpyridine, 2-ethylpyridine, 4-ethylpyridine, 2-phenylpyridine, 4-phenylpyridine, 2-methyl-4-phenylpyridine, nicotine, nicotinic acid, nicotinamide, quinoline, 4-hydroxyquinoline, 8-oxyquinoline, and acridine; piperazines such as piperazine and 1-(2-hydroxyethyl)piperazine; pyrazine, pyrazole, pyridazine, quinoxaline, purine, pyrrolidine, piperidine, 3-piperidino-1,2-propanediol, morpholine, 4-methylmorpholine, 1,4-dimethylpiperazine, and 1,4-diazabicyclo[2.2.2]octane.

These acid diffusion controllers may be used either individually or in combinations of two or more.

The amount of the acid diffusion controller to be added is usually 100 mol% or less, preferably 50 mol% or less, and still more preferably 30 mol% or less, of the acid generator (b). If the amount of the acid diffusion controller exceeds 100 mol%, sensitivity of the resulting resist and developability of the exposed region may be decreased. If the amount of the acid diffusion controller is less than 0.1 mol%, the pattern shape or dimensional accuracy of the resulting resist may be decreased depending on the process conditions.

As preferable examples of dissolution controllers, a compound shown by the following formula (17) (hereinafter referred to as "dissolution controller (δ1)"), a compound shown by the following formula (18) (hereinafter referred to as "dissolution controller (δ2)"), a polyketone having a recurring unit shown by the following formula (20) (hereinafter referred to as "dissolution controller (δ3)"), a polyspiroketal having a recurring unit shown by the following formula (21) (hereinafter referred to as "dissolution controller (δ4)"), and the like can be given. As more preferable examples of the dissolution controllers, at least one compound selected from the group consisting of the dissolution controller (δ1) and the dissolution controller (δ2) and/or at least one compound selected from the group consisting of the dissolution controller (δ3) and the dissolution controller (δ4) can be given. The addition of such a dissolution controller ensures appropriate control of the dissolution contrast and the dissolution rate of the resist.

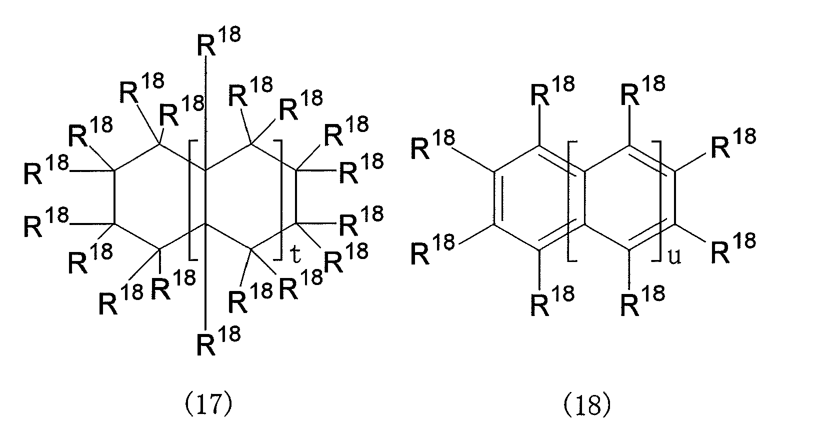

In the formulas (17) and (18), R¹⁸ individually represents a hydrogen atom, a fluorine atom, a linear or branched alkyl group having 1 to 10 carbon atoms, a linear or branched fluoroalkyl group having 1 to 10 carbon atoms, or a group represented by the following formula (19), 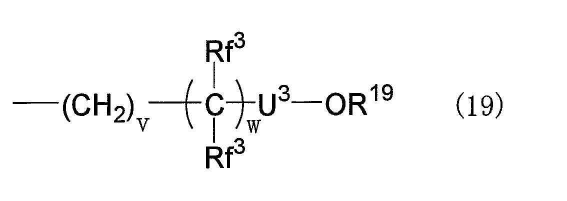 wherein Rf³ individually represents a hydrogen atom, a methyl group, or a trifluoromethyl group, U³ is a single bond, a methylene group, a cyclohexylene group, or a phenylene group, R¹⁹ represents a hydrogen atom or a monovalent organic group dissociating with an acid to produce a hydrogen atom, v is an integer of 0 to 3, and w is 0 or 1, at least one of R¹⁸s being the group shown by the formula (19), and t and u individually represent an integer of 0 to 2.

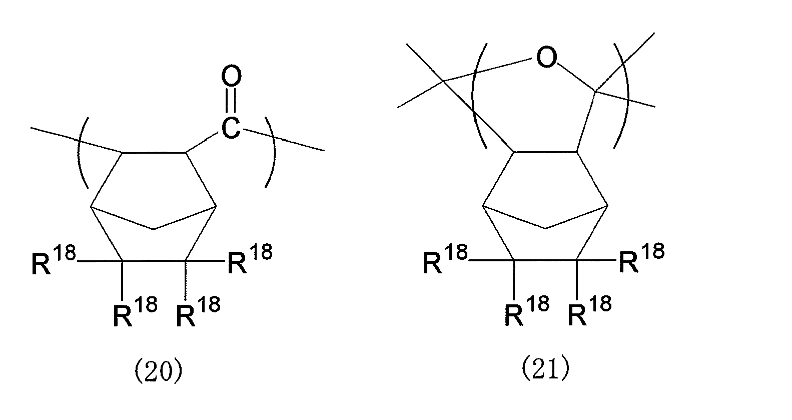

In the formulas (20) and (21), R¹⁸ is the same as defined for the above formulas (17) and (18).

As examples of the linear or branched alkyl group having 1 to 10 carbon atoms represented by R¹⁸ in the formula (17), (18), (20), or (21), a methyl group, ethyl group, n-propyl group, i-propyl group, n-butyl group, i-butyl group, sec-butyl group, t-butyl group, n-pentyl group, n-hexyl group, n-heptyl group, n-octyl group, n-nonyl group, and n-decyl group can be given.

As examples of the linear or branched fluoroalkyl group having 1 to 10 carbon atoms represented by R¹⁸, a fluoromethyl group, difluoromethyl group, trifluoromethyl group, pentafluoroethyl group, heptafluoro-n-propyl group, heptafluoro-i-propyl group, nonafluoro-n-butyl group, perfluoro-n-pentyl group, perfluoro-n-hexyl group, perfluoro-n-heptyl group, perfluoro-n-octyl group, perfluoro-n-nonyl group, and perfluoro-n-decyl group can be given.

The two bonding sites in the cyclohexylene group and phenylene group represented by U³ in the group of the above formula (19) representing the R¹⁸ may be 1,2-, 1,3-, or 1,4-positions.

As examples of the monovalent organic group dissociable by the action of an acid to produce hydrogen atoms represented by R¹⁹, organocarbonyl groups such as a t-butoxycarbonyl group, methoxycarbonyl group, ethoxycarbonyl group, i-propoxycarbonyl group, 9-fluorenylmethylcarbonyl group, 2,2,2-trichloroethylcarbonyl group, 2-(trimethylsilyl)ethylcarbonyl group, i-butylcarbonyl group, vinylcarbonyl group, allylcarbonyl group, benzylcarbonyl group, 4-ethoxy-1-naphthylcarbonyl group, and methyldithiocarbonyl group; alkyl-substituted alicyclic group such as a 1-methylcyclopentyl group, 1-ethylcyclopentyl group, 1-methylcyclohexyl group, 1-ethylcyclohexyl group, 2-methyladamantan-2-yl group, 2-ethyladamantan-2-yl group, 2-methylbicyclo[2.2.1]heptan-2-yl group, and 2-ethylbicyclo[2.2.1]heptan-2-yl group; organic groups bonding to the oxygen atom in the formula (19) to form an acetal structure such as a methoxymethyl group, methylthiomethyl group, ethoxymethyl group, ethylthiomethyl group, t-butoxymethyl group, t-butylthiomethyl group, (phenyldimethylsilyl)methoxymethyl group, benzyloxymethyl group, t-butoxymethyl group, siloxymethyl group, 2-methoxyethoxymethyl group, 2,2,2-trichloroethoxymethyl group, bis(2-chloroethoxy)methyl group, 2-(trimethylsilyl)ethoxymethyl group, 1-methoxycyclohexyl group, tetrahydropyranyl group, 4-methoxytetrahydropyranyl group, tetrahydrofuranyl group, tetrahydrothiopyranyl group, tetrahydrothiofuranyl group, 1-methoxyethyl group, 1-ethoxyethyl group, 1-(2-chloroethoxy)ethyl group, 1-methyl-1-methoxyethyl group, 1-methyl-1-benzyloxyethyl group, 1-(2-chloroethoxy)ethyl group, 1-methyl-1-benzyloxy-2-fluoroethyl group, 2,2,2-trichloroethyl group, 2-trimethylsilylethyl group, and 2-(phenylselenyl)ethyl group;
alkylsilyl groups such as a trimethylsilyl group, ethyldimethylsilyl group, triethylsilyl group, i-propyldimethylsilyl group, i-propyldiethylsilyl group, tri-i-propylsilyl group, t-butyldimethylsilyl group, t-butyldiphenylsilyl group, tribenzylsilyl group, tri-p-xylylsilyl group, methyldiphenylsilyl group, triphenylsilyl group, and t-butylmethoxyphenylsilyl group; and the like can be given.

Of these monovalent organic groups dissociable with an acid to produce hydrogen atoms, t-butoxycarbonyl group, methoxymethyl group, ethoxymethyl group, 1-methoxyethyl group, 1-ethoxyethyl group, and the like are preferable.

As preferable examples of the dissolution controller (δ1), compounds shown by the following formulas (δ1-1) to (δ1-4) can be given.

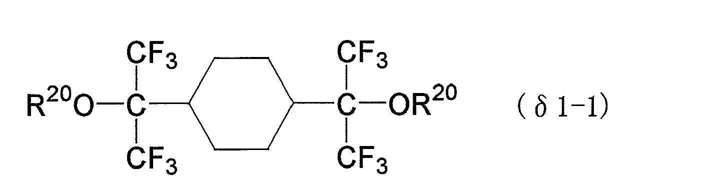

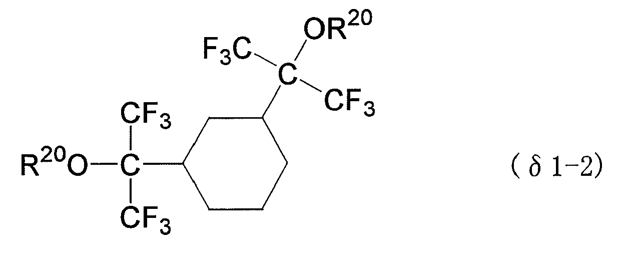

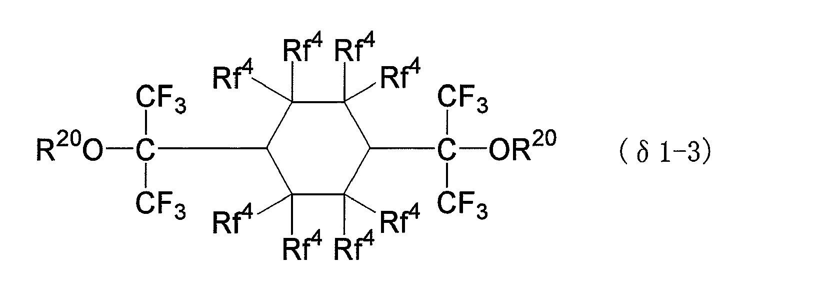

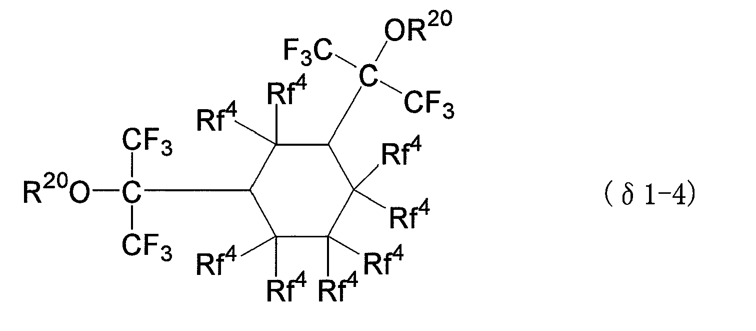

In formulas (δ1-1) to (δ1-4), R²⁰ individually represents a hydrogen atom, t-butoxycarbonyl group, methoxymethyl group, ethoxymethyl group, 1-methoxyethyl group, or 1-ethoxyethyl group and Rf⁴ individually represents a hydrogen atom, fluorine atom, or trifluoromethyl group, provided that eight Rf⁴ groups in the formulas (δ1-3) and (δ1-4) cannot be a hydrogen atom at the same time.

As preferable examples of the dissolution controller (δ2), compounds shown by the following formulas (δ2-1) to (δ2-5) can be given.

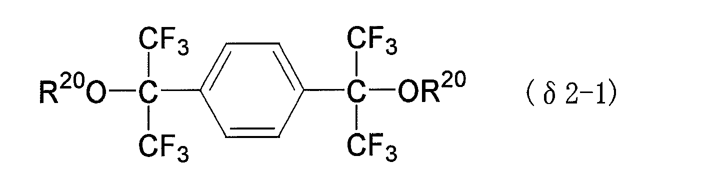

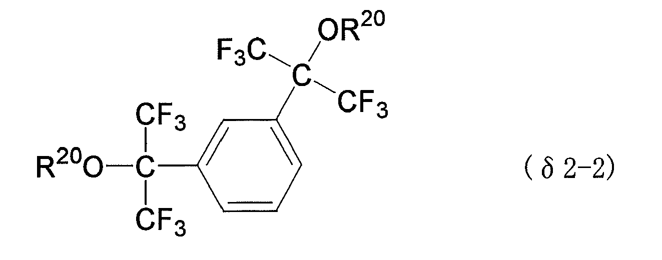

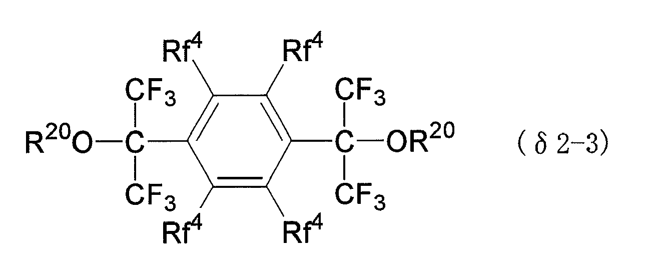

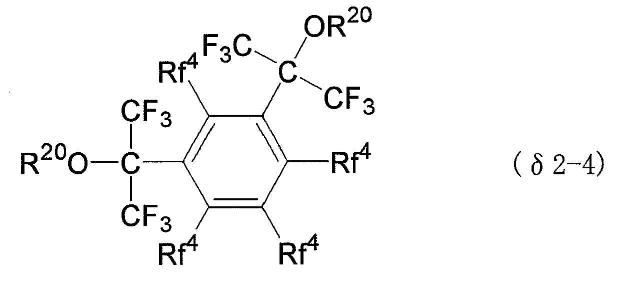

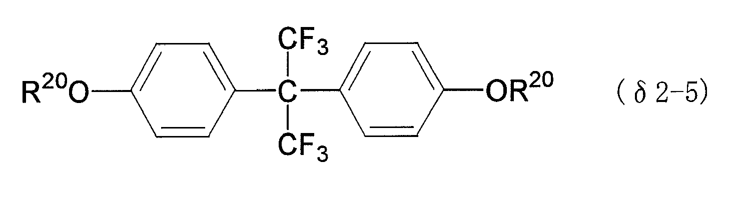

In the formulas (δ2-1) to (δ2-5), R²⁰ and Rf⁴ are respectively the same as those defined in the above formulas (δ1-1) to (δ1-4), provided that four Rf⁴ groups in the formulas (δ2-3) and (δ2-4) cannot be a hydrogen atom at the same time.

As the dissolution controller (δ1), the compounds of the following formula (δ1-1-1), formula (δ1-1-2), formula (δ1-2-1), and formula (δ1-2-2), for example, are more preferable. As the dissolution controller (δ2), the compounds of the following formula (δ2-1-1), formula (δ2-1-2), formula (δ2-2-1), formula (δ2-2-2), and formula (δ2-5-1), for example, are more preferable.

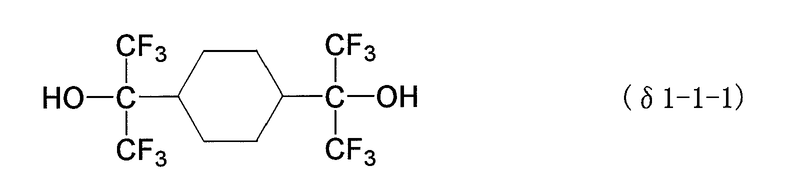

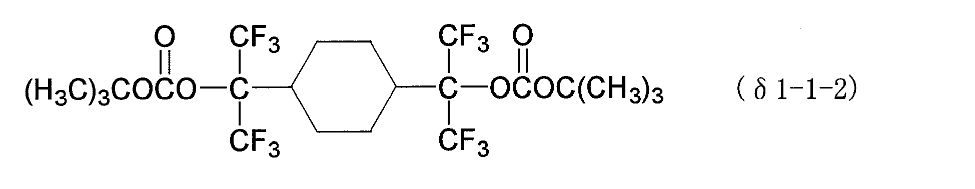

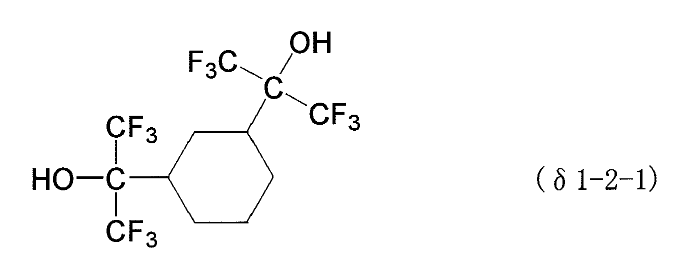

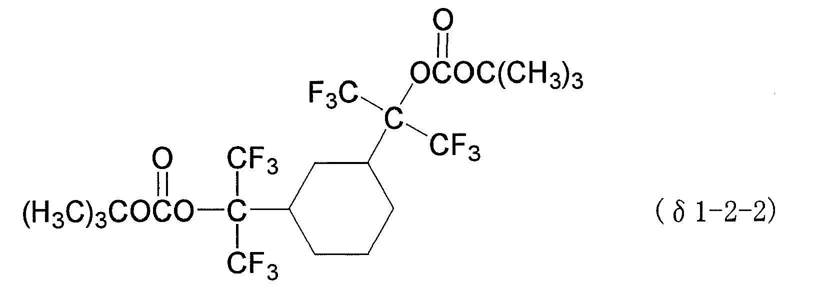

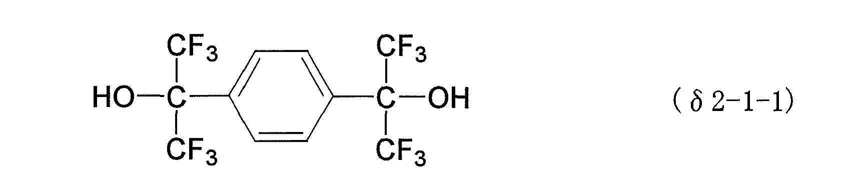

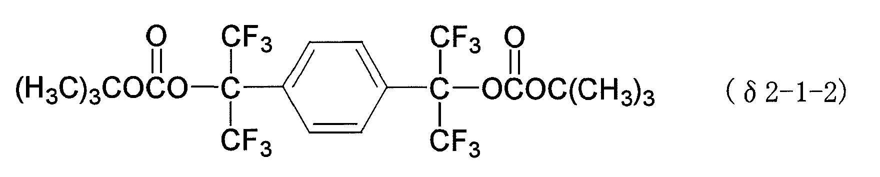

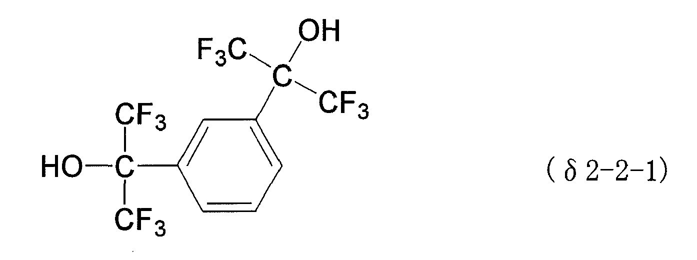

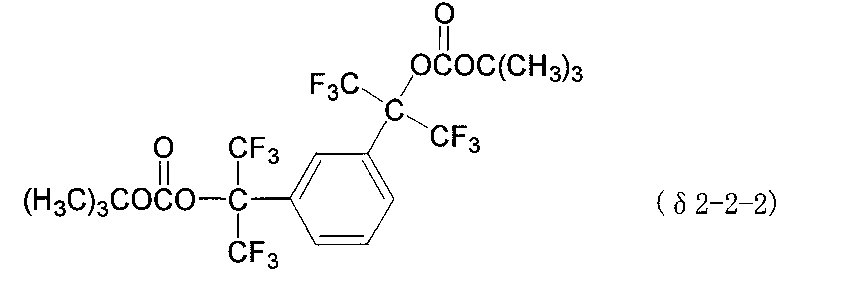

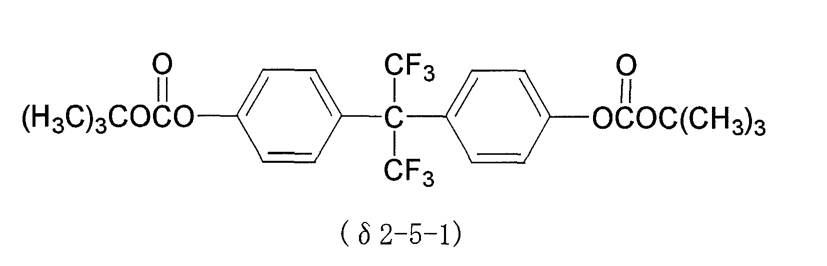

As the dissolution controller (δ4), a polyspiroketal having a recurring unit of the following formula (δ4-1) is more preferable.

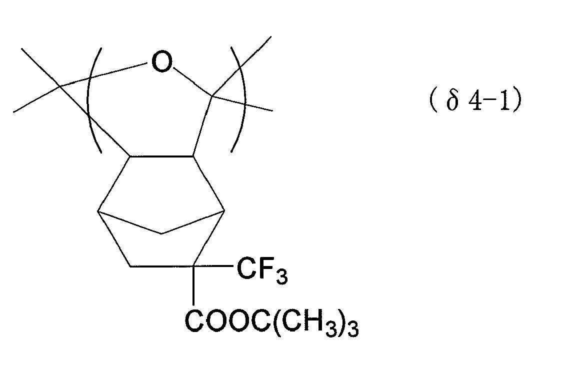

The polyketone used as a dissolution controller (δ3) and the polyspiroketal used as a dissolution controller (δ4) have an Mw usually of 300-100,000, and preferably 800-3,000.

The amount of the dissolution controllers to be added is usually 50 parts by weight or less, and preferably 30 parts by weight or less for 100 parts by weight of the total resin component. If the amount of the dissolution controller exceeds 50 parts by weight, heat resistance as a resist tends to decrease.

The surfactant improves applicability, striation, developability, and the like of the radiation-sensitive resin composition.

As examples of the surfactant, nonionic surfactants such as polyoxyethylene lauryl ether, polyoxyethylene stearyl ether, polyoxyethylene oleyl ether, polyoxyethylene n-octylphenyl ether, polyoxyethylene n-nonylphenyl ether, polyethylene glycol dilaurate, and polyethylene glycol distearate; and commercially available products such as KP341 (manufactured by Shin-Etsu Chemical Co., Ltd.), POLYFLOW No. 75, No. 95 (manufactured by Kyoeisha Chemical Co., Ltd.), FTOP EF301, EF303, EF352 (manufactured by Tohkem Products Corporation), MEGAFAC F171, F173 (manufactured by Dainippon Ink and Chemicals, Inc.), Fluorad FC430, FC431 (manufactured by Sumitomo 3M Ltd.), Asahi Guard AG710, and Surflon S-382, SC-101, SC-102, SC-103, SC-104, SC-105, SC-106 (manufactured by Asahi Glass Co., Ltd.) can be given.

These surfactants may be used either individually or in combination of two or more.

The amount of the surfactants to be added is usually 2 parts by weight or less for 100 parts by weight of the total resin component.

As other additives, halation inhibitors, adhesion promoters, storage stabilizers, anti-foaming agents, and the like can be given.

### <Preparation of composition solution>

The radiation-sensitive resin composition of the present invention is usually used in the form of a composition solution prepared by dissolving the composition in a solvent so that the total solid content is usually 1-25 wt%, and preferably 2-15 wt%, and filtering the solution using a filter with a pore diameter of about 0.2 µm, for example.

As examples of solvents used for preparation of the composition solution, linear or branched ketones such as 2-butanone, 2-pentanone, 3-methyl-2-butanone, 2-hexanone, 4-methyl-2-pentanone, 3-methyl-2-pentanone, 3,3-dimethyl-2-butanone, 2-heptanone, and 2-octanone; cyclic ketones such as cyclopentanone, 3-methylcyclopentanone, cyclohexanone, 2-methylcyclohexanone, 2,6-dimethylcyclohexanone, and isophorone; propylene glycol monoalkyl ether acetates such as propylene glycol monomethyl ether acetate, propylene glycol monoethyl ether acetate, propylene glycol mono-n-propyl ether acetate, propylene glycol mono-i-propyl ether acetate, propylene glycol mono-n-butyl ether acetate, propylene glycol mono-i-butyl ether acetate, propylene glycol mono-sec-butyl ether acetate, and propylene glycol mono-t-butyl ether acetate; alkyl 2-hydroxypropionates such as methyl 2-hydroxypropionate, ethyl 2-hydroxypropionate, n-propyl 2-hydroxypropionate, i-propyl 2-hydroxypropionate, n-butyl 2-hydroxypropionate, i-butyl 2-hydroxypropionate, sec-butyl 2-hydroxypropionate, and t-butyl 2-hydroxypropionate; alkyl 3-alkoxypropionates such as methyl 3-methoxypropionate, ethyl 3-methoxypropionate, methyl 3-ethoxypropionate, and ethyl 3-ethoxypropionate; fluorine-containing solvents such as: fluorine-containing alcohols such as 2,3-difluorobenzyl alcohol, 2,2,2-trifluoroethanol, 1,3-difluoro-2-propanol, 1,1,1-trifluoro-2-propanol, 3,3,3-trifluoro-1-propanol, 2,2,3,3,4,4,4-heptafluoro-1-butanol, 2,2,3,3,4,4,5,5-octafluoro-1-pentanol, 3,3,4,4,5,5,5-heptafluoro-2-pentanol, 1H,1H-perfluoro-1-octanol, 1H,1H,2H,2H-perfluoro-1-octanol, 1H,1H,9H-perfluoro-1-nonanol, 1H,1H,2H,3H,3H-perfluorononane-1,2-diol, 1H,1H,2H,2H-perfluoro-1-decanol, and 1H,1H,2H,3H,3H-perfluoroundecane-1,2-diol; fluorine-containing esters such as 2,2,2-trifluoroethyl butyrate, ethyl heptafluorobutyrate, ethyl heptafluorobutylacetate, ethyl hexafluoroglutarate, ethyl 3-hydroxy-4,4,4-trifluorobutyrate, ethyl 2-methyl-4,4,4-trifluoroacetoacetate, ethyl pentafluorobenzoate, ethyl pentafluoropropionate, ethyl pentafluoropropionate, ethyl perfluorooctanoate, ethyl 4,4,4-trifluoroacetoacetate, ethyl 4,4,4-trifluorobutyrate, ethyl 4,4,4-trifluorocrotonate, ethyl trifluorosulfonate, ethyl 3-(trifluoromethyl)butyrate, ethyl trifluoropyruvate, ethyl trifluoroacetate, isopropyl 4,4,4-trifluoroacetoacetate, methyl perfluorodecanoate, methyl perfluoro(2-methyl-3-oxahexanoate), methyl perfluorononanoate, methyl perfluorooctanoate, methyl 2,3,3,3-tetrafluoropropionate, methyl trifluoroacetoacetate, methyl perfluoro(2,5,8-trimethyl-3,6,9-trioxadodecanoate), propylene glycol trifluoromethyl ether acetate, propylene glycol methyl ether trifluoromethylacetate, n-butyl trifluoromethylacetate, methyl 3-trifluoromethoxypropionate, 1,1,1-trifluoro-2-propyl acetate, and n-butyl trifluoroacetate; fluorine-containing ethers such as 2-fluoroanisole, 3-fluoroanisole, 4-fluoroanisole, 2,3-difluoroanisole, 2,4-difluoroanisole, 2,5-difluoroanisole, 5,8-difluoro-1,4-benzodioxane, trifluoroacetaldehydeethylhemiacetal, 2H-perfluoro(5-methyl-3,6-dioxanonane), 2H-perfluoro(5,8,11,14-tetramethyl-3,6,9,12,15-pentaoxaoctadecane), (perfluoro-n-butyl)tetrahydrofuran, perfluoro(n-butyltetrahydrofuran), and propylene glycol trifluoromethyl ether; fluorine-containing ketones such as 2,4-difluoropropiophenone, fluorocyclohexane, 1,1, 1,2,2,3,3-heptafluoro-7,7-dimethyl-4,6-octanedione, 1,1,1,3,5,5,5-heptafluoropentane-2,4-dione, 3,3,4,4,5,5,5-heptafluoro-2-pentanone, 1,1,1,2,2,6,6,6-octafluoro-2,4-hexanedione, trifluorobutanol-1,1,1-trifluoro-5-methyl-2,4-hexanedione, and perfluorocyclohexanone; fluorine-containing amines such as trifluoroacetamide, perfluorotributylamine, perfluorotrihexylamine, perfluorotripentylamine, and perfluorotripropylamine; and fluorine-substituted cyclic hydrocarbons such as 2,4-difluorotoluene, perfluorodecalin, perfluoro(1,2-dimethylcyclohexane), and perfluoro(1,3-dimethylcyclohexane); n-propyl alcohol, i-propyl alcohol, n-butyl alcohol, t-butyl alcohol, cyclohexanol, ethylene glycol monomethyl ether, ethylene glycol monoethyl ether, ethylene glycol mono-n-propyl ether, ethylene glycol mono-n-butyl ether, diethylene glycol dimethyl ether, diethylene glycol diethyl ether, diethylene glycol di-n-propyl ether, diethylene glycol di-n-butyl ether, ethylene glycol monomethyl ether acetate, ethylene glycol monoethyl ether acetate, ethylene glycol mono-n-propyl ether acetate, propylene glycol monomethyl ether, propylene glycol monoethyl ether, propylene glycol mono-n-propyl ether, toluene, xylene, ethyl 2-hydroxy-2-methylpropionate, ethyl ethoxyacetate, ethyl hydroxyacetate, methyl 2-hydroxy-3-methylbutyrate, 3-methoxybutyl acetate, 3-methyl-3-methoxybutyl acetate, 3-methyl-3-methoxybutyl propionate, 3-methyl-3-methoxybutyl butyrate, ethyl acetate, n-propyl acetate, n-butyl acetate, methyl acetoacetate, ethyl acetoacetate, methyl pyruvate, ethyl pyruvate, N-methylpyrrolidone, N,N-dimethylformamide, N,N-dimethylacetamide, benzyl ethyl ether, di-n-hexyl ether, diethylene glycol monomethyl ether, diethylene glycol monoethyl ether, caproic acid, caprylic acid, 1-octanol, 1-nonanol, benzyl alcohol, benzyl acetate, ethyl benzoate, diethyl oxalate, diethyl maleate, γ-butyrolactone, ethylene carbonate, and propylene carbonate can be given.

These solvents may be used either individually or in combination of two or more. Among these solvents, linear or branched ketones, cyclic ketones, propylene glycol monoalkyl ether acetates, alkyl 2-hydroxypropionates, alkyl 3-alkoxypropionates, and fluorine-containing solvents are preferable.

### <Formation of resist pattern>

In the radiation-sensitive resin composition of the present invention, an acid is generated from the acid generator (b) upon exposure to radiation. The acid-dissociable group in the siloxane resin (α) dissociates by the action of the acid and generates a carboxyl group or a hydroxyl group. As a result, solubility of the exposed part of the resist in an alkaline developer increases, whereby the exposed part is dissolved in an alkaline developer and removed to produce a positive-tone resist pattern.

A resist pattern is formed from the radiation-sensitive resin composition of the present invention by applying the composition solution to a silicon wafer, a wafer coated with aluminum, a substrate on which an under layer film is previously formed, or the like using an appropriate application method such as rotational coating, cast coating, and roll coating to form a resist film. After optionally treating with heat (hereinafter referred to as "PB" or "pre-baking"), the resist film is exposed to radiation to form a prescribed resist pattern. Deep ultraviolet rays such as an F₂ excimer laser (wavelength: 157 nm) ArF excimer laser (wavelength: 193 nm), electron beams, X-rays, and the like are preferable as the radiation used here.

In the present invention, it is preferable to perform post-exposure bake (hereinafter called "PEB") after exposure. The PEB ensures a smooth dissociation reaction of the acid-dissociable group from the siloxane resin (α). The heating temperature for PEB is usually 30 to 200°C, and preferably 50 to 170°C, although the heating conditions vary depending on the composition of the resist.

In order to exploit the potential performance of the radiation-sensitive resin composition of the present invention to the maximum extent, an organic or inorganic under layer film may be formed on the substrate used (see e.g. Patent Document 9), or in order to prevent the effect of basic impurities and the like contained in the environmental atmosphere, a protective film may be formed on a resist film (see e.g. Patent Document 10). These measures may be used in combination.
Patent Document 9: JP-B-6-12452
Patent Document 10: JP-A-5-188598

The exposed resist film is then developed to form a prescribed resist pattern.

As examples of the developer used for development, alkaline aqueous solutions prepared by dissolving at least one of alkaline compounds such as sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, tetramethylammonium hydroxide, pyrrole, piperidine, choline, 1,8-diazabicyclo-[5.4.0]-7-undecene, and 1,5-diazabicyclo-[4.3.0]-5-nonene are preferable.

The concentration of the alkaline aqueous solution is usually 10 wt% or less. If the concentration of the alkaline aqueous solution exceeds 10 wt%, an unexposed part may be dissolved in the developer.

Organic solvents or the like may be added to the developer containing the alkaline aqueous solution.

As examples of the organic solvents, ketones such as acetone, 2-butanone, 4-methyl-2-pentanone, cyclopentanone, cyclohexanone, 3-methylcyclopentanone, and 2,6-dimethylcyclohexanone; alcohols such as methyl alcohol, ethyl alcohol, n-propyl alcohol, i-propyl alcohol, n-butyl alcohol, t-butyl alcohol, cyclopentanol, cyclohexanol, 1,4-hexanediol, and 1,4-hexanedimethylol; ethers such as tetrahydrofuran and dioxane; esters such as ethyl acetate, n-butyl acetate, and i-amyl acetate; aromatic hydrocarbons such as toluene and xylene; phenol, acetonylacetone, and dimethylformamide can be given.

These organic solvents may be used either individually or in combination of two or more.

The amount of the organic solvent to be used is preferably 100 vol% or less of the alkaline aqueous solution. The amount of the organic solvent exceeding 100 vol% may decrease developability, giving rise to a larger undeveloped portion in the exposed area.

In addition, surfactants or the like may be added to the developer containing the alkaline aqueous solution in an appropriate amount.

After development using the alkaline aqueous solution developer, the resist film is generally washed with water and dried.

### BEST MODE FOR CARRYING OUT THE INVENTION

The present invention is described below in more detail by examples. However, these examples should not be construed as limiting the present invention.

### Mw:

Mw of the siloxane resin (a) and polymers used for an under layer film-forming composition was measured by gel permeation chromatography (GPC) using GPC columns (manufactured by Tosoh Corp., G2000HXL × 2, G3000HXL × 1, G4000HXL × 1) under the following conditions. Flow rate: 1.0 ml/minute, eluate: tetrahydrofuran, column temperature: 40°C, standard reference material: monodispersed polystyrene

### Synthesis Example 1 (Preparation of siloxane resin (α-1))

A three-necked flask equipped with a stirrer, a reflux condenser, and a thermometer was charged with 42.8 g of a silane compound shown by the following formula (i-1), 16.3 g of a silane compound shown by the following formula (iii-1) (hereinafter referred to as "silane compound (iii-1)"), 14.4 g of a silane compound shown by the following formula (ii-1) (hereinafter referred to as "silane compound (ii-1)"), 26.5 g of a silane compound shown by the following formula (v-1) (hereinafter referred to as "silane compound (v-1)"), 100 g of 4-methyl-2-pentanone, and 27.2 g of a 1.75 wt% aqueous solution of oxalic acid. The mixture was reacted at 60°C for six hours while stirring. The flask was cooled with ice to terminate the reaction.

40.1 g of distilled water and 56.3 g of triethylamine were added to the reaction solution and stirred at 80°C in a nitrogen stream for six hours, followed by cooling with ice. An aqueous solution of 42.3 g of oxalic acid dissolved in 562.4 g of distilled water was added to the mixture, followed by further stirring. The reaction solution was poured into a separating funnel to remove the water layer. The organic layer was repeatedly washed with ion-exchanged water until the reaction solution became neutral.

Then, the resulting reaction mixture was condensed to a concentration of 50 wt% to obtain a resin solution. After the addition of 516 g of methanol, the mixture was stirred to obtain a homogeneous solution, which was poured into a separating funnel. 825 g of n-heptane was added to separate the mixture into two layers. The liquid separated into two layers was vigorously stirred for two minutes and allowed to stand at room temperature for 30 minutes. The lower layer was removed and transferred into an eggplant flask. The solvent was replaced with 4-methyl-2-pentanone while concentrating the solution to purify the resin. The solvent was evaporated under reduced pressure from the solution to obtain 58.8 g of a purified resin. Mw of the resin was 1,820. This resin is referred to as a "siloxane resin (α-1)".

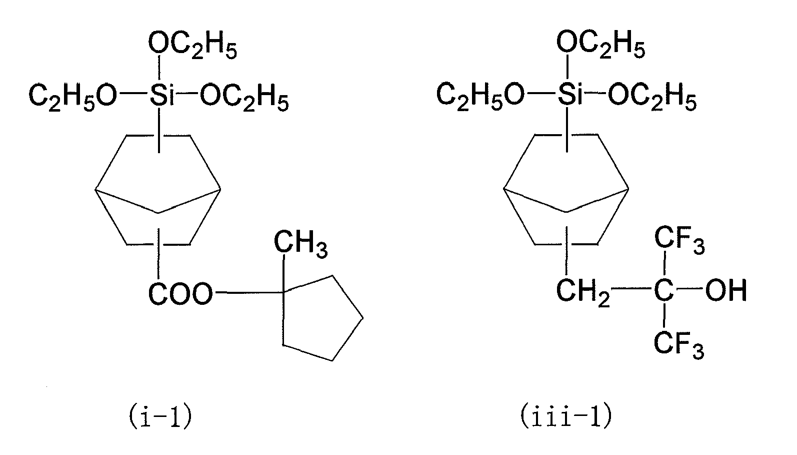

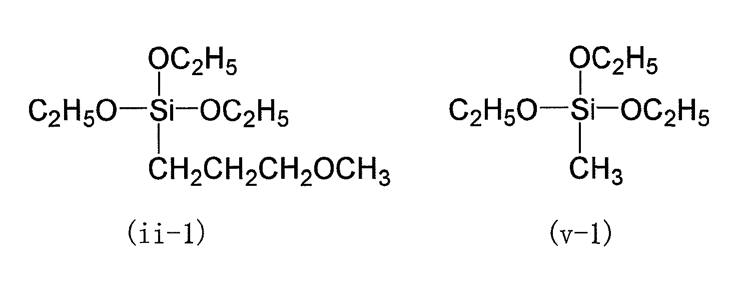

### Synthesis Example 2 (Preparation of siloxane resin (α-2))

A three-necked flask equipped with a stirrer, a reflux condenser, and a thermometer was charged with 45.3 g of a silane compound shown by the following formula (i-2) (hereinafter referred to as "silane compound (i-2)"), 15.6 g of the silane compound (iii-1), 13.8 g of the silane compound (ii-1), 23.5 g of the silane compound (v-1), 100 g of 4-methyl-2-pentanone, and 26.0 g of a 1.75 wt% aqueous solution of oxalic acid. The mixture was reacted at 60°C for six hours while stirring. The flask was cooled with ice to terminate the reaction.

38.4 g of distilled water and 53.9 g of triethylamine were added to the reaction solution and stirred at 80°C in a nitrogen stream for six hours, followed by cooling with ice. An aqueous solution of 40.5 g of oxalic acid dissolved in 538.3 g of distilled water was added to the mixture, followed by further stirring. The reaction solution was poured into a separating funnel to remove the water layer. The organic layer was repeatedly washed with ion-exchanged water until the reaction solution became neutral.

Then, the resulting reaction mixture was condensed to a concentration of 50 wt% to obtain a resin solution. After the addition of 529 g of methanol, the mixture was stirred to obtain a homogeneous solution, which was poured into a separating funnel. 847 g of n-heptane was added to separate the mixture into two layers. The liquid separated into two layers was vigorously stirred for two minutes and allowed to stand at room temperature for 30 minutes. The lower layer was removed and transferred into an eggplant flask. The solvent was replaced with 4-methyl-2-pentanone while concentrating the solution to purify the resin. The solvent was evaporated under reduced pressure from the solution to obtain 60.4 g of a purified resin. Mw of the resulting resin was 2,340. This resin is referred to as a "siloxane resin (α-2)".

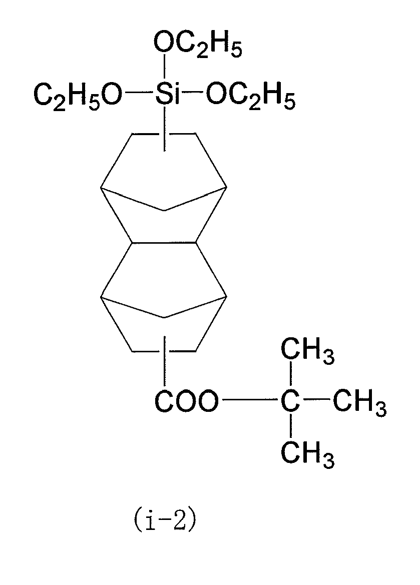

### Synthesis Example 3 (Preparation of siloxane resin (α-3))

A three-necked flask equipped with a stirrer, a reflux condenser, and a thermometer was charged with 46.52 g of a silane compound (i-1), 27.43 g of a silane compound shown by the following formula (ii-2) (hereinafter referred to as "silane compound (ii-2)"), 26.04 g of the silane compound (v-1), 100 g of 4-methyl-2-pentanone, and 26.8 g of a 1.75 wt% aqueous solution of oxalic acid. The mixture was reacted at 60°C for six hours while stirring. The flask was cooled with ice to terminate the reaction.

39.5 g of distilled water and 56.2 g of triethylamine were added to the reaction solution and stirred at 80°C in a nitrogen stream for six hours, followed by cooling with ice. An aqueous solution of 41.6 g of oxalic acid dissolved in 595.0 g of distilled water was added to the mixture, followed by further stirring. The reaction solution was poured into a separating funnel to remove the water layer. The organic layer was repeatedly washed with ion-exchanged water until the reaction solution became neutral.

Then, the resulting reaction mixture was condensed to a concentration of 50 wt% to obtain a resin solution. After the addition of 496 g of methanol, the mixture was stirred to obtain a homogeneous solution, which was poured into a separating funnel. 793 g of n-heptane was added to separate the mixture into two layers. The liquid separated into two layers was vigorously stirred for two minutes and allowed to stand at room temperature for 30 minutes. The lower layer was removed and transferred into an eggplant flask. The solvent was replaced with 4-methyl-2-pentanone while concentrating the solution to purify the resin. The solvent was evaporated under reduced pressure from the solution to obtain 56.6 g of a purified resin. Mw of the resin was 2,210. This resin is referred to as a "siloxane resin (α-3)".

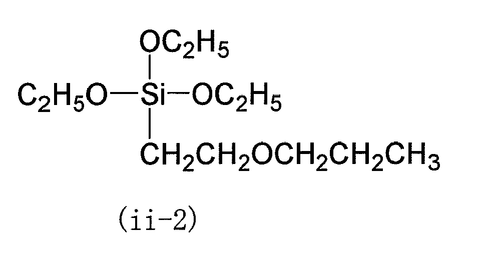

### Synthesis Example 4 (Preparation of siloxane resin (α-4))

A three-necked flask equipped with a stirrer, a reflux condenser, and a thermometer was charged with 46.52 g of a silane compound (i-1), 27.43 g of a silane compound shown by the following formula (ii-3) (hereinafter referred to as "silane compound (ii-3)"), 26.04 g of the silane compound (v-1), 100 g of 4-methyl-2-pentanone, and 26.8 g of a 1.75 wt% aqueous solution of oxalic acid. The mixture was reacted at 60°C for six hours while stirring. The flask was cooled with ice to terminate the reaction.

39.5 g of distilled water and 56.2 g of triethylamine were added to the reaction solution and stirred at 80°C in a nitrogen stream for six hours, followed by cooling with ice. An aqueous solution of 41.6 g of oxalic acid dissolved in 595.0 g of distilled water was added to the mixture, followed by further stirring. The reaction solution was poured into a separating funnel to remove the water layer. The organic layer was repeatedly washed with ion-exchanged water until the reaction solution became neutral.

Then, the resulting reaction mixture was condensed to a concentration of 50 wt% to obtain a resin solution. After the addition of 496 g of methanol, the mixture was stirred to obtain a homogeneous solution, which was poured into a separating funnel. 793 g of n-heptane was added to separate the mixture into two layers. The liquid separated into two layers was vigorously stirred for two minutes and allowed to stand at room temperature for 30 minutes. The lower layer was removed and transferred into an eggplant flask. The solvent was replaced with 4-methyl-2-pentanone while concentrating the solution to purify the resin. The solvent was evaporated under reduced pressure from the solution to obtain 57.3 g of a purified resin. Mw of the resin was 2,290. This resin is referred to as a "siloxane resin (α-4)".

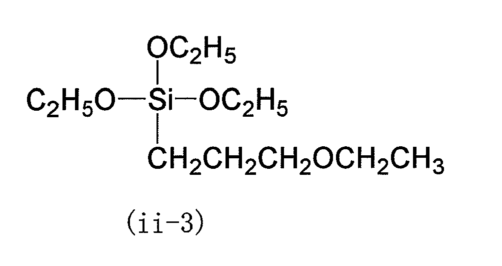

### Comparative Synthesis Example 1

A three-necked flask equipped with a stirrer, a reflux condenser, and a thermometer was charged with 50.5 g of the silane compound (i-2), 49.5 g of the silane compound (v-1), 100 g of 4-methyl-2-pentanone, and 29.1 g of a 1.75 wt% aqueous solution of oxalic acid. The mixture was reacted at 60°C for six hours while stirring. The flask was cooled with ice to terminate the reaction.

42.9 g of distilled water and 60.2 g of triethylamine were added to the reaction solution and stirred at 80°C in a nitrogen stream for six hours, followed by cooling with ice. An aqueous solution of 45.2 g of oxalic acid dissolved in 645.9 g of distilled water was added to the mixture, followed by further stirring. The reaction solution was poured into a separating funnel to remove the water layer. The organic layer was repeatedly washed with ion-exchanged water until the reaction solution became neutral.

Then, the resulting reaction mixture was condensed to a concentration of 50 wt% to obtain a resin solution. After the addition of 467 g of methanol, the mixture was stirred to obtain a homogeneous solution, which was poured into a separating funnel. 747 g of n-heptane was added to separate the mixture into two layers. The liquid separated into two layers was vigorously stirred for two minutes and allowed to stand at room temperature for 30 minutes. The lower layer was removed and transferred into an eggplant flask. The solvent was replaced with 4-methyl-2-pentanone while concentrating the solution to purify the resin. The solvent was evaporated under reduced pressure from the solution to obtain 42.0 g of a purified resin. Mw of the resulting resin was 2,850. This resin is referred to as a "siloxane resin (r-1)".

### Preparation Example (Preparation of under layer film-forming composition)

A separable flask equipped with a thermometer was charged with 100 parts by weight of acenaphthylene, 78 parts by weight of toluene, 52 parts by weight of dioxane, and 3 parts by weight of azobisisobutyronitrile in a nitrogen atmosphere. The mixture was stirred for five hours at 70°C. Next, 5.2 parts by weight of p-toluenesulfonic acid monohydrate and 40 parts by weight of paraformaldehyde were added. After heating to 120°C, the mixture was stirred for six hours. The reaction solution was poured into a large amount of isopropyl alcohol. The resulting precipitate was collected by filtration and dried at 40°C under reduced pressure to obtain a polymer having a Mw of 22,000.

10 parts by weight of the obtained polymer, 0.5 part by weight of bis(4-t-butylphenyl)iodonium 10-camphorsulfonate, and 0.5 part by weight of 4,4'-[1-{4-(1-[4-hydroxyphenyl]-1-methylethyl)phenyl} ethylidene]bisphenol were dissolved in 89 parts by weight of cyclohexanone to prepare a homogeneous solution. The solution was filtered using a membrane filter with a pore diameter of 0.1 µm to prepare an under layer film-forming composition.

### Comparative Examples 1-4 and Comparative Evaluation Example 1

Composition solutions were prepared by homogeneously mixing 100 parts by weight of siloxane resins shown in Table 1, 900 parts by weight of 2-heptanone, and the acid generators (b) shown Table 1.

The composition solutions were applied onto a silicon wafer substrate with an under layer film previously formed thereon by spin coating and pre-baked for 90 seconds on a hot plate at 100°C to form a resist film with a thickness of 150 nm.

The under layer film had a thickness of 300 nm, prepared by applying the above-mentioned under layer film-forming composition onto a silicon wafer by spin coating and baking the coating on a hot plate at 180°C for 60 seconds and further baking at 300°C for 120 seconds.

The resist films were exposed to an ArF excimer laser (wavelength: 193 nm, NA: 0.78, σ: 0.85) through a mask with a pattern of ϕ 130 nm contact holes at a pitch of 200 nm formed over the entire surface using an ArF excimer laser exposure apparatus ("S306C" manufactured by Nikon Corp.), while changing the amount of exposure. The films were then heated on a hot plate at 100°C for 90 seconds (PEB). The resist films were developed using a 2.38 wt% tetramethylammonium hydroxide aqueous solution at 23°C for 60 seconds, washed with water, and dried to form a positive-tone resist pattern.

### Preparation of substrate for development defect inspection

The composition solutions were applied onto a silicon wafer substrate with an antireflection film ("ARC29A" manufactured by Nissan Chemical Industries, Ltd.) with a thickness of 77 nm previously formed thereon, and pre-baked for 90 seconds at 100°C to obtain a resist film with a dry thickness of 150 nm. The resist films were exposed to an ArF excimer laser through a mask using an ArF excimer laser exposure apparatus ("S306C" manufactured by Nikon Corp.) to form a pattern of ϕ 110 nm contact holes at a pitch of 300 nm formed. After exposure and post exposure baking (PEB) at 100°C for 90 seconds, the resist film was developed at 23°C for 60 seconds in a 2.38 wt% tetramethylammonium hydroxide aqueous solution, washed with water, and dried to form a substrate for development defect inspection. Application of the composition solutions, PB, PEB, and development were carried out using an inline system ("ACT8" manufactured by Tokyo Electron Ltd.).

The evaluation was conducted according to the following procedure. The evaluation results are shown in Table 1.

### Sensitivity

An optimum exposure dose at which a hole-and-space (1H1S) pattern with a contact hole diameter of 100 nm was formed was taken as sensitivity.

### Depth of focus (DOF)

A hole-and-space pattern (1H1S) with a contact hole diameter of 100 nm was formed by irradiating light at an optimum exposure dose while moving the focus to determine a focus range in which the contact hole diameter was in a range from 90 nm to 110 nm.

### Development defects

Development defects were evaluated using the substrate for development defect inspection using a defect inspection apparatus ("KLA2351" manufactured by KLA-Tencor Corp.). The number of development defects was calculated by detecting development defects extracted from the difference obtained by superposing the pixel units and a reference image in an array mode of the defect inspection apparatus at a pixel size of 0.16 µm and a ceiling value of 13.

The acid generators (b) in Table 1 are as follows.
Acid generator (b)
b-1: Triphenylsulfonium nonafluoro-n-butanesulfonate
b-2: Triphenylsulfonium 10-camphorsulfonate

**Table 1**

| | Siloxane resin (part by weight) | Acid generator (b) (part by weight) | Sensitivity (J/m²) | Depth of focus (µm) | Development defects number |
|---|---|---|---|---|---|
| Comparative Example 1 | α-1 (100) | b-1 (5.0) | 300 | 0.4 | 15 |
| | | b-2 (1.5) | | | |
| Comparative Example 2 | α-2 (100) | b-1 (5.0) | 410 | 0.4 | 8 |
| | | b-2 (1.5) | | | |
| Comparative Example 3 | α-3 (100) | b-1 (5.0) | 450 | 0.4 | 11 |
| | | b-2 (1.5) | | | |
| Comparative Example 4 | α-4 (100) | b-1 (5.0) | 460 | 0.4 | 20 |
| | | b-2 (1.5) | | | |
| Comparative Evaluation Example 1 | r-1 (100) | b-1 (5.0) | 900 | 0.2 | > 125,000 |
| | | b-2 (1.5) | | | |

### INDUSTRIAL APPLICABILITY

The siloxane resin (α) of the present invention exhibits high transparency at a wavelength of 193 nm or less and can be used very suitably as a resin component in a radiation-sensitive resin composition useful particularly for manufacturing LSIs.

The radiation-sensitive resin composition of the present invention is useful as a chemically-amplified resist, exhibiting high transparency at a wavelength of 193 nm or less, excellent depth of focus (DOF), and capability of remarkably decreasing development defects, and excelling in sensitivity, resolution, pattern-forming properties, and the like. Therefore, the radiation-sensitive resin composition of the present invention can be used very suitably particularly for manufacturing LSIs which are expected to become miniaturized more and more in the future.

## Claims

1. A siloxane resin having a structural unit (I) shown by the following formula (I) and a structural unit (II) shown by the following formula (II) in the same molecule, the content of the structural unit (I) in the total structural units being more than 0 mol% but not more than 70 mol% and the content of the structural unit (II) in the total structural units being more than 0 mol% but not more than 70 mol%, and possessing a polystyrene-reduced weight average molecular weight determined by gel permeation chromatography (GPC) in the range of 500 to 1,000,000, 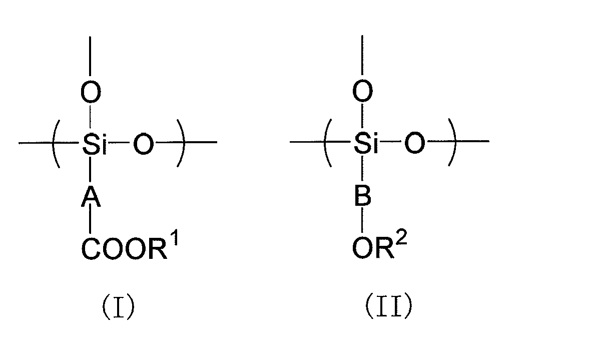 wherein A represents a substituted or unsubstituted divalent linear, branched, or cyclic hydrocarbon group having 1 to 20 carbon atoms and R¹ represents a monovalent acid-dissociable group and B represents a divalent linear, branched, or cyclic hydrocarbon group having 1 to 20 carbon atoms, which may be substituted with a group not containing a fluorine atom, and R² represents a substituted or unsubstituted linear, branched, or cyclic alkyl group having 1 to 20 carbon atoms.

2. The siloxane resin according to claim 1, wherein the structural unit (I) represented by the formula (I) is one or more units selected from the group consisting of the units shown by the following formulas (I-1), (I-2), (I-3), (I-4), and (I-5), and the structural unit (II) represented by the formula (II) is one or more units selected from the group consisting of the units shown by the following formulas (II-1), (II-2), (II-3), (II-4), (II-5), and (II-6), wherein the units shown by the formulas (II-4), (II-5), and (II-6) may be substituted with a linear or branched alkyl group having 1 to 20 carbon atoms, 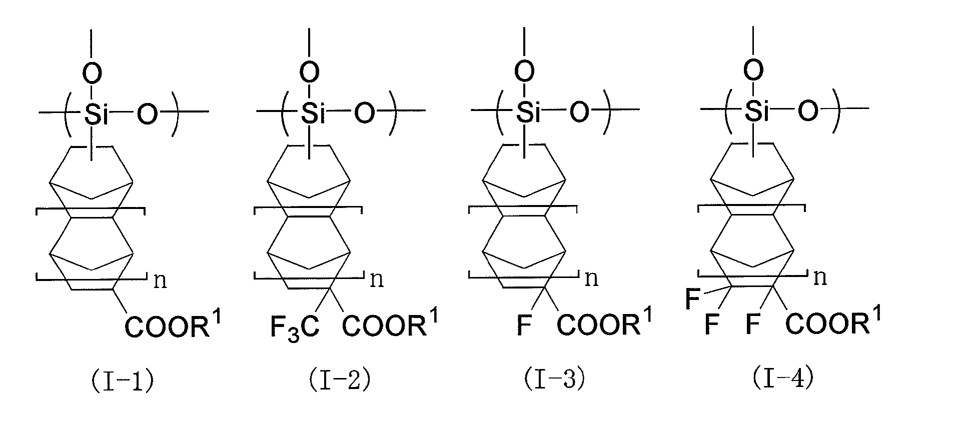 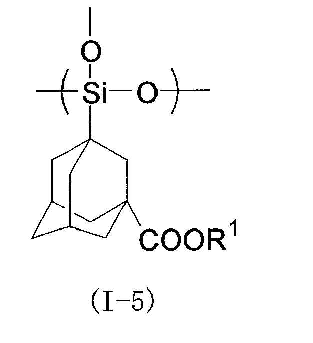 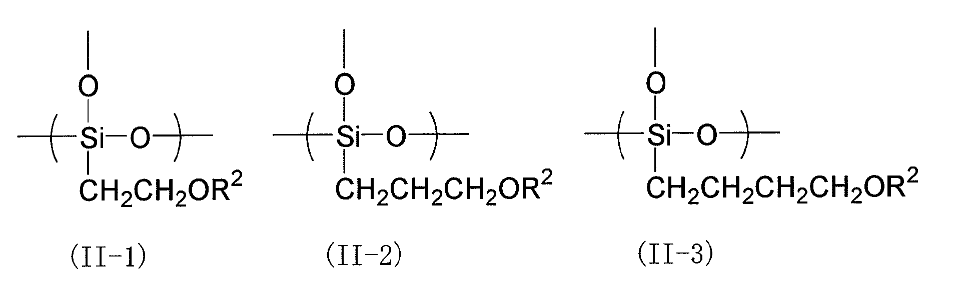 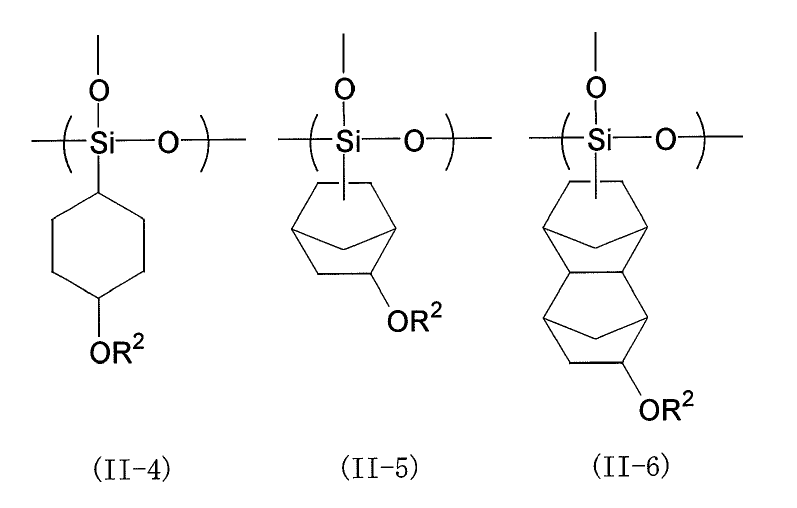 wherein n is 0 or 1.

3. The siloxane resin according to claim 1 or claim 2, wherein R¹ in the formula (I) is a t-butyl group, 1-methylcyclopentyl group, 1-ethylcyclopentyl group, 1-methylcyclohexyl group, 1-ethylcyclohexyl group, 2-methyladamantyl group, 2-ethyladamantyl group, or t-butoxycarbonylmethyl group, and R² in the formula (II) is a methyl group, ethyl group, n-propyl group, i-propyl group, n-butyl group, t-butyl group, n-pentyl group, or n-hexyl group.

4. The siloxane resin according to claim 1, claim 2, or claim 3, wherein the content of the structural unit (I) shown by the formula (I) is 10 to 60 mol% and the content of the structural unit (II) shown by the formula (II) is 1 to 50 mol%.

5. A siloxane resin having a structural unit (I) shown by the following formula (I), a structural unit (II) shown by the following formula (II), and a structural unit (III) shown by the following formula (III) and/or a structural unit (IV) shown by the following formula (IV) in the same molecule, the content of the structural unit (I) in the total structural units being more than 0 mol% but not more than 70 mol% and the content of the structural unit (II) in the total structural units being more than 0 mol% but not more than 70 mol%, and total amount of the structural unit (III) and the structural unit (IV) being more than 0 mol% but not more than 70 mol%, and possessing a polystyrene-reduced weight average molecular weight determined by gel permeation chromatography (GPC) in the range of 500 to 1,000,000, 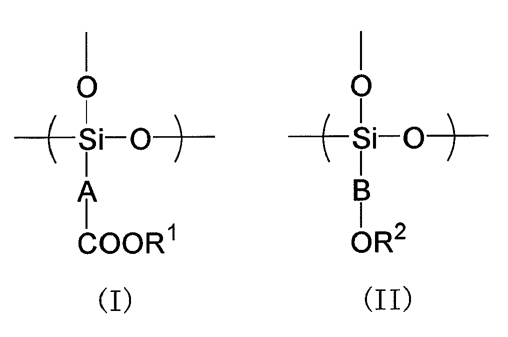 wherein A represents a substituted or unsubstituted divalent linear, branched, or cyclic hydrocarbon group having 1 to 20 carbon atoms and R¹ represents a monovalent acid-dissociable group and B represents a divalent linear, branched, or cyclic hydrocarbon group having 1 to 20 carbon atoms, which may be substituted with a group not containing a fluorine atom, and R² represents a substituted or unsubstituted linear, branched, or cyclic alkyl group having 1 to 20 carbon atoms, 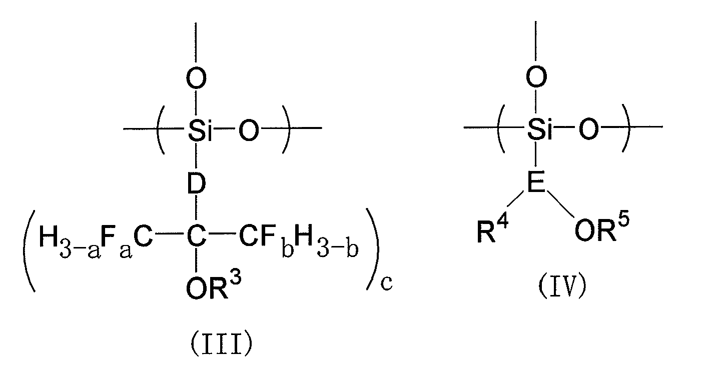 wherein, D represents a substituted or unsubstituted, linear or branched hydrocarbon group having 1 to 20 carbon atoms with a valence of (c+1) or a substituted or unsubstituted alicyclic hydrocarbon group having 3 to 20 carbon atoms with a valence of (c+1), R³ represents a hydrogen atom or a monovalent acid dissociable group, a and b are individually an integer of 0 to 3 satisfying the formula (a + b) ≥ 1, and c is an integer of 1 to 3, E represents a substituted or unsubstituted trivalent alicyclic hydrocarbon group having 3 to 20 carbon atoms or a substituted or unsubstituted trivalent heterocyclic group having 3 to 20 atoms, R⁴ represents a fluorine atom or a linear or branched fluoroalkyl group having 1 to 4 carbon atoms, and R⁵ represents a hydrogen atom or a monovalent acid-dissociable group.

6. The siloxane resin according to claim 5, wherein the structural unit (I) represented by the formula (I) is one or more units selected from the group consisting of the units shown by the following formulas (I-1), (I-2), (I-3), (I-4), and (I-5), the structural unit (II) represented by the formula (II) is one or more units selected from the group consisting of the units shown by the following formulas (II-1), (II-2), (II-3), (II-4), (II-5), and (II-6), wherein the units shown by the formulas (II-4), (II-5), and (II-6) may be substituted with a linear or branched alkyl group having 1 to 20 carbon atoms, the structural unit (III) represented by the formula (III) is one or more units selected from the group consisting of the units shown by the following formulas (III-1), (III-2), (III-3), (III-4), and (III-5), and the structural unit (IV) represented by the formula (IV) is one or more units selected from the group consisting of the units shown by the following formulas (IV-1), (IV-2), (IV-3), (IV-4), (IV-5), (IV-6), and (IV-7), 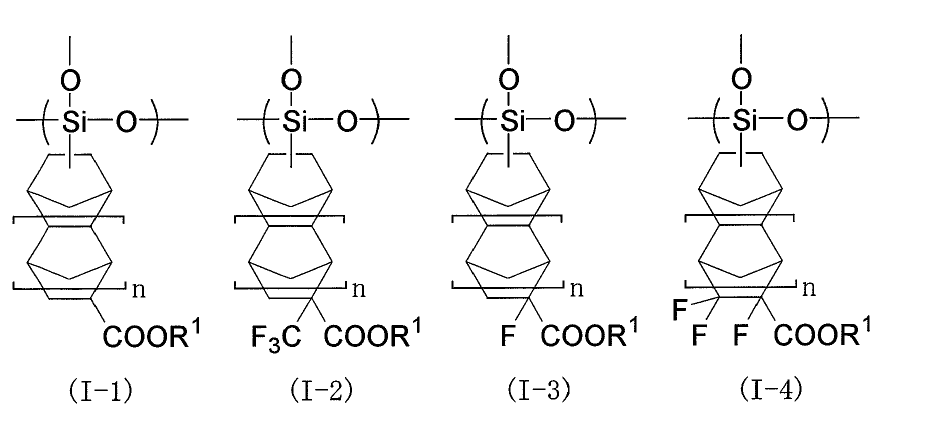 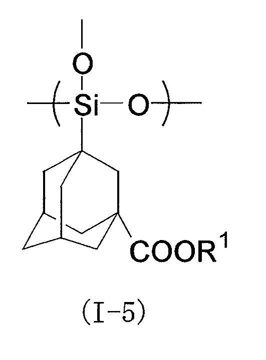 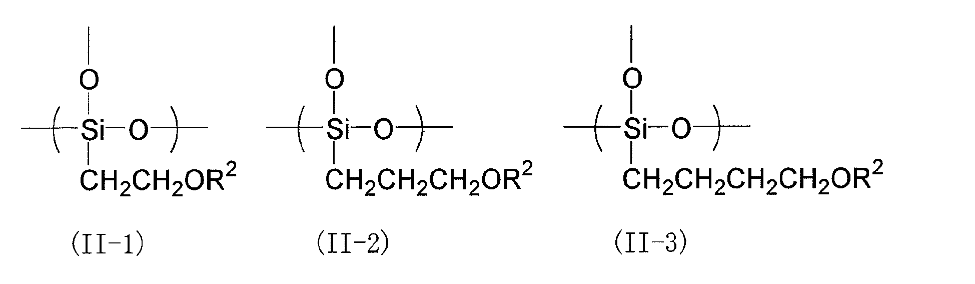 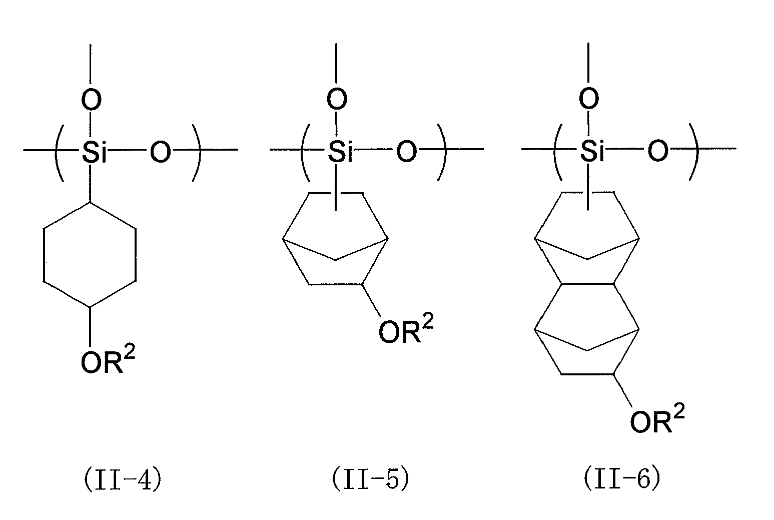 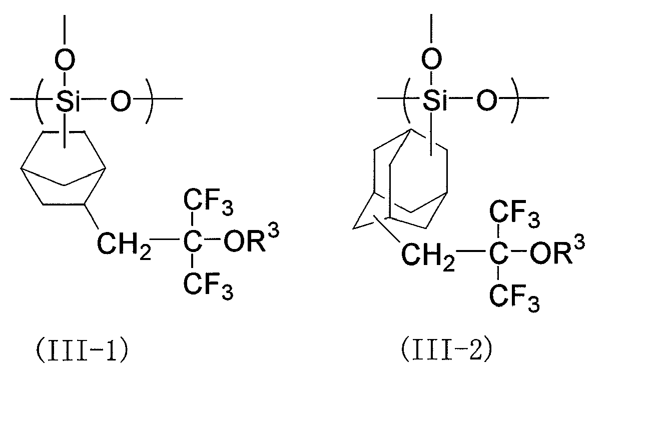 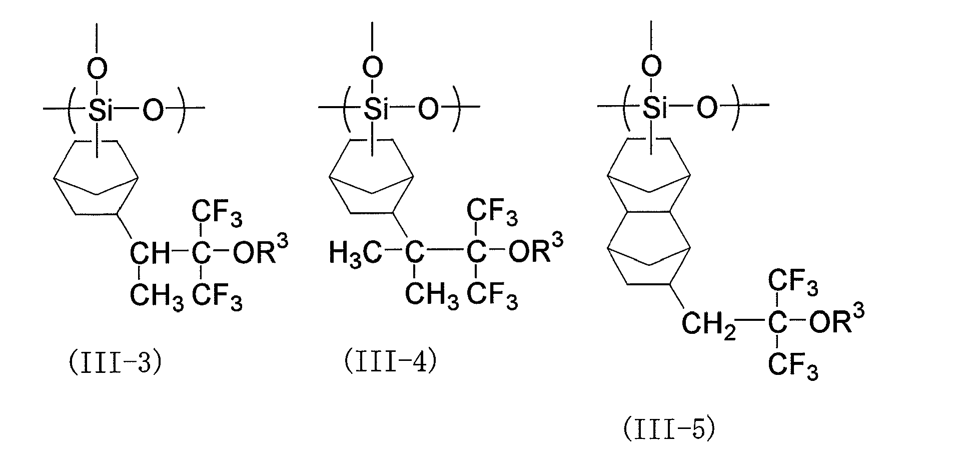 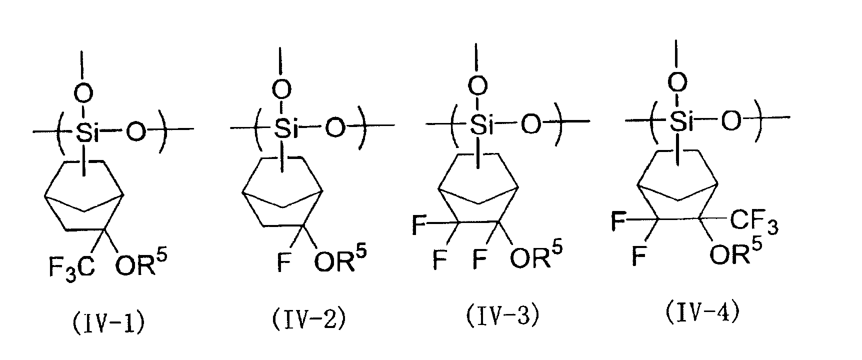 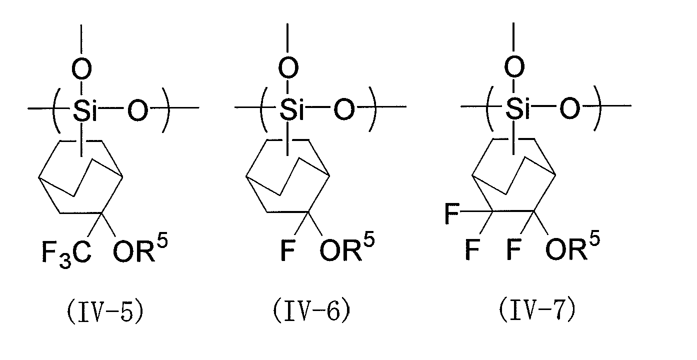 wherein n is 0 or 1.

7. The siloxane resin according to claim 5 or claim 6 wherein R¹ in the formula (I) is a t-butyl group, 1-methylcyclopentyl group, 1-ethylcyclopentyl group, 1-methylcyclohexyl group, 1-ethylcyclohexyl group, 2-methyladamantyl group, 2-ethyladamantyl group, or t-butoxycarbonylmethyl group, R² in the formula (II) is a methyl group, ethyl group, n-propyl group, i-propyl group, n-butyl group, t-butyl group, n-pentyl group, or n-hexyl group, R³ in the formula (III) is a hydrogen atom, methoxymethyl group, ethoxymethyl group, or t-butoxycarbonyl group, and R⁵ in the formula (IV) is a hydrogen atom, methoxymethyl group, ethoxymethyl group, or t-butoxycarbonyl group.

8. The siloxane resin according to claim 5, claim 6, or claim 7, wherein the content of the structural unit (I) shown by the formula (I) is 10 to 60 mol%, the content of the structural unit (II) shown by the formula (II) is 1 to 50 mol%, the total content of the structural unit (III) shown by the formula (III) and the structural unit (IV) shown by the formula (IV) is 1 to 50 mol%.

9. A radiation-sensitive resin composition comprising (a) the siloxane resin according to claim 1 or claim 2 and (b) a photoacid generator.

10. A radiation-sensitive resin composition comprising (a) the siloxane resin according to claim 3 and (b) a photoacid generator.

11. A radiation-sensitive resin composition comprising (a) the siloxane resin according to claim 4 and (b) a photoacid generator.

12. A radiation-sensitive resin composition comprising (a) the siloxane resin according to claim 5 or claim 6 and (b) a photoacid generator.

13. A radiation-sensitive resin composition comprising (a) the siloxane resin according to claim 7 and (b) a photoacid generator.

14. A radiation-sensitive resin composition comprising (a) the siloxane resin according to claim 8 and (b) a photoacid generator.
